(19) Europäisches Patentamt
European Patent Office
Office européen des brevets

(11) **EP 4 765 649 A1**

(12) **EUROPEAN PATENT APPLICATION**

(43) Date of publication:
24.06.2026 Bulletin 2026/26

(21) Application number: 25224298.7

(22) Date of filing: 17.12.2025

(51) International Patent Classification (IPC):
*H03M 7/30* *(2006.01)*

(52) Cooperative Patent Classification (CPC):
H03M 7/3077; H03M 7/3071

(84) Designated Contracting States:
AL AT BE BG CH CY CZ DE DK EE ES FI FR GB GR HR HU IE IS IT LI LT LU LV MC ME MK MT NL NO PL PT RO RS SE SI SK SM TR
Designated Extension States:
BA
Designated Validation States:
GE KH LA MA MD TN

(30) Priority: 19.12.2024 GB 202418731

(71) Applicant: Imagination Technologies Limited
Kings Langley, Hertfordshire WD4 8LZ (GB)

(72) Inventors:
• Demirci, Gunduz Vehbi
Kings Langley, WD4 8LZ (GB)
• Atherton, Timothy James
Kings Langley, WD4 8LZ (GB)
• Imber, James Stuart
Kings Langley, WD4 8LZ (GB)
• Fenney, Simon James
Kings Langley, WD4 8LZ (GB)

(74) Representative: Slingsby Partners LLP
1 Kingsway
London WC2B 6AN (GB)

(54) **COMPRESSING A SET OF VALUES**

(57) A computer-implemented method of compressing a set of values, the method comprising: determining a matrix comprising the set of values; assessing a similarity between pairs of rows and/or pairs of columns of the matrix; reordering the rows and/or columns of the matrix in dependence on the similarity between the pairs of rows and/or pairs of columns so as to form a plurality of groups of values of the set of values; and compressing at least one group of values of the plurality of groups of values so as to compress the set of values.

FIGURE 5A

EP 4 765 649 A1

**Description**

CROSS-REFERENCE TO RELATED APPLICATION

This application claims priority from UK patent application 2418731.2 filed on 19 December 2024, which is herein incorporated by reference in its entirety.

TECHNICAL FIELD

The present disclosure is directed to methods of, and processing systems for, compressing a set of values.

BACKGROUND

In computer-implemented applications, sets of values are often written into memory, and subsequently read from memory. For example, a set of values that are to be processed may be received at a processing system and written into a memory comprised by that processing system. Subsequently, that set of values can be read from the memory into processing logic comprised by that processing system for processing. In some examples, a set of values may be a set of pixel values representing an image, a set of audio samples representing an audio signal, or a set of weights of a layer of a neural network.

An amount of data (e.g. a number of bits of data) is required to represent a set of values. The larger the amount of data required to represent a set of values, the larger the amount of space in memory that set of values consumes. In other words, the larger the memory footprint of that set of values. Further, the larger the amount of data required to represent a set of values, the larger the amount of bandwidth (e.g. "memory bandwidth") consumed to write that set of values into, and read that set of values from, memory. This can increase the latency, and power consumption, associated with writing that set of values into, and reading that set of values from, memory - which can increase the latency, and power consumption, associated with processing that set of values.

As such, it is often desirable to compress sets of values. A set of values can be compressed such that a smaller amount of data (e.g. fewer bits of data) are required to represent that set of values. The smaller the amount of data required to represent a set of values, the smaller the amount of space in memory that set of values consumes. In other words, the smaller the memory footprint of that set of values. Further, the smaller the amount of data required to represent a set of values, the smaller the amount of bandwidth (e.g. "memory bandwidth") consumed to write that data into, and read that data from, memory. This can decrease the latency, and power consumption, associated with writing that set of values into, and reading that set of values from, memory - which can decrease the latency, and power consumption, associated with processing that set of values. Put another way, a compressed set of values can be stored in, and transferred to/from, memory more efficiently.

SUMMARY

This Summary is provided to introduce a selection of concepts in a simplified form that are further described below in the Detailed Description. This Summary is not intended to identify key features or essential features of the claimed subject matter, nor is it intended to be used to limit the scope of the claimed subject matter.

According to a first aspect of the present invention there is provided a computer-implemented method of compressing a set of values, the method comprising: determining a matrix comprising the set of values; assessing a similarity between pairs of rows and/or pairs of columns of the matrix; reordering the rows and/or columns of the matrix in dependence on the similarity between the pairs of rows and/or pairs of columns so as to form a plurality of groups of values of the set of values; and compressing at least one group of values of the plurality of groups of values so as to compress the set of values.

Assessing the similarity between the pairs of rows of the matrix may comprise, for each row of the matrix, assessing the similarity between that row of the matrix and, respectively, each other row of the matrix; and/or assessing the similarity between the pairs of columns of the matrix may comprise, for each column of the matrix, assessing the similarity between that column of the matrix and, respectively, each other column of the matrix.

Assessing the similarity between the pairs of rows and/or the pairs of columns of the matrix may comprise: assessing the similarity in values comprised by the pairs of rows and/or the pairs of columns of the matrix; and/or assessing the similarity in the minimum number of bits required to encode values comprised by the pairs of rows and/or the pairs of columns of the matrix.

Assessing the similarity between the pairs of rows and/or the pairs of columns of the matrix may comprise determining one or more of an L1 distance, an L2 distance, a cosine similarity and a Minkowski distance between: the values comprised by the pairs of rows and/or the pairs of columns of the matrix; and/or the minimum number of bits required to encode values comprised by the pairs of rows and/or the pairs of columns of the matrix.

Reordering the rows and/or columns of the matrix may comprise: reordering the rows of the matrix in dependence on the similarity between the pairs of rows so as to form a plurality of one-dimensional, vertical, groups of values; or reordering columns of the matrix in dependence on the similarity between the pairs of columns so as to form a plurality of one-dimensional, horizontal, groups of values; or reordering the rows of the matrix in dependence on the similarity between the pairs of rows, and reordering columns of the matrix in dependence on the similarity between the pairs of columns, so as to form a plurality of two-dimensional groups of values.

The computer-implemented method may comprise reordering the rows and/or columns of the matrix in dependence on the similarity between the pairs of rows and/or pairs of columns so as to form a plurality of groups of values in which values of the set of values having greater similarity are preferentially grouped together and in which values of the set of values having lesser similarity are preferentially separated into different groups of the plurality of groups of values.

Reordering the rows and/or columns of the matrix may comprise: reordering the rows of the matrix so as to form a plurality of groups of rows in which pairs of rows having greater similarity are preferentially grouped together and in which pairs of rows having lesser similarity are preferentially separated into different groups of the plurality of groups of rows; and/or reordering the columns of the matrix so as to form a plurality of groups of columns in which pairs of columns having greater similarity are preferentially grouped together and in which pairs of columns having lesser similarity are preferentially separated into different groups of the plurality of groups of columns.

The matrix may be a one-dimensional matrix or a two-dimensional matrix.

Each of the plurality of groups of values may comprise a plurality of values of the set of values.

Compressing a group of values may comprise: determining a plurality of encodable values in dependence on that group of values; identifying a sufficient number of bits required to encode the encodable value of the plurality of encodable values that has the greatest magnitude; and encoding each of the encodable values of the plurality of encodable values using that number of bits.

Compressing the at least one group of values may comprise compressing one or more groups of values according to a first compression scheme in which, for each of said one or more groups of values, each value of that group of values is encoded using a number of bits sufficient to represent the value in that group of values that has the greatest magnitude.

Compressing the at least one group of values may comprise compressing one or more groups of values according to a second compression scheme in which, for each of the one or more groups of values: a base value is determined in dependence on the values of that group of values; for each of one or more values of that group of values, a respective difference between that value and the base value is determined; the base value is encoded using a number of bits sufficient to represent the base value; and each of the one or more differences are encoded using a number of bits sufficient to represent the difference of the one or more differences that has the greatest magnitude.

Compressing the at least one group of values may comprise compressing one or more groups of values according to a third compression scheme in which, for each of the one or more groups of values: a base value is determined in dependence on the values of that group of values; a base difference is determined between the base value and a first value of that group of values; for each of one or more values of that group of values other than the first value, a respective adjacency difference between that value and an adjacent value of that group of values is determined; the base value is encoded using a number of bits sufficient to represent the base value; and each of the base difference and the one or more adjacency differences are encoded using a number of bits sufficient to represent the difference of the base difference and the one or more adjacency differences that has the greatest magnitude.

Compressing the at least one group of values may comprise, for each of one or more groups of values to be compressed: assessing the number of bits that would be required to encode that group of values according to two or more of the first compression scheme, the second compression scheme and the third compression scheme; and compressing that group of values according to the compression scheme of the assessed compression schemes that will require the fewest number of bits to encode that group of values.

Determining the base value may comprise determining the minimum value, the maximum value, the median value, the mode value or the mean of that group of values to be the base value.

Compressing the at least one group of values may further comprise, for each of one or more groups of values to be compressed, sorting the values of that group into ascending or descending order prior to compressing that group of values according to the second compression scheme or the third compression scheme.

The set of values may comprise or represent a set of weights of a layer of a neural network.

The method may comprise, so as to form the plurality of groups of values of the set of values: reordering the rows or columns of the matrix in dependence on the similarity between the pairs of rows or pairs of columns; and reordering the other of the rows or columns of the matrix to correspond with the reordering of rows or columns of a further matrix comprising a further set of values comprising or representing a further set of weights of an adjacent layer of the neural network.

The rows of the matrix may be representative of output channels of the set of weights of the layer of the neural network and the columns of the matrix may be representative of input channels of the set of weights of the layer of the neural network, and the method may comprise, so as to form the plurality of groups of values of the set of values: reordering the rows of the matrix in dependence on the similarity between the pairs of rows, and reordering the columns of the matrix to correspond with the reordering of rows of a further matrix comprising a further set of values comprising or representing a further set of weights of a preceding layer of the neural network, said rows of the further matrix being representative of output channels of the further set of weights of the preceding layer that correspond with the input channels of the layer represented by the columns of the matrix; or reordering the columns of the matrix in dependence on the similarity between the pairs of columns, and reordering the rows of the matrix to correspond with the reordering of columns of a further matrix comprising a further set of values comprising or representing a further set of weights of a subsequent layer of the neural network, said columns of the further matrix being representative of input channels of the further set of weights of the subsequent layer that correspond with the output channels of the layer represented by the rows of the matrix.

The columns of the matrix may be representative of output channels of the set of weights of the layer of the neural network and the rows of the matrix may be representative of input channels of the set of weights of the layer of the neural network, and the method may comprise, so as to form the plurality of groups of values of the set of values: reordering the rows of the matrix in dependence on the similarity between the pairs of rows, and reordering the columns of the matrix to correspond with the reordering of rows of a further matrix comprising a further set of values comprising or representing a further set of weights of a subsequent layer of the neural network, said rows of the further matrix being representative of input channels of the further set of weights of the subsequent layer that correspond with the output channels of the layer represented by the columns of the matrix; or reordering the columns of the matrix in dependence on the similarity between the pairs of columns, and reordering the rows of the matrix to correspond with the reordering of columns of a further matrix comprising a further set of values comprising or representing a further set of weights of a preceding layer of the neural network, said columns of the further matrix being representative of output channels of the further set of weights of the preceding layer that correspond with the input channels of the layer represented by the rows of the matrix.

The set of values may comprise or represent a set of weights of a first two-dimensional plane of a four-dimensional set of weights of a convolutional layer of the neural network, and the method may further comprise: determining a second matrix comprising a second set of values, the second set of values comprising or representing a second set of weights of a second two-dimensional plane of the four-dimensional set of weights of the convolutional layer of the neural network; assessing a similarity between pairs of rows and/or pairs of columns of the second matrix; combining the assessed similarity between the pairs of rows and/or pairs of columns of the matrix and the assessed similarity between the corresponding pairs of rows and/or pairs of columns of the second matrix; reordering the rows and/or columns of the matrix in dependence on the combined assessed similarity so as to form the plurality of groups of values of the set of values; reordering the rows and/or columns of the second matrix in dependence on the combined assessed similarity so as to form a plurality of groups of values of the second set of values, wherein the reordering of the rows and/or columns of the second matrix corresponds with the reordering of the rows and/or columns of the matrix; and compressing at least one group of values of the plurality of groups of values of the second set of values so as to compress the second set of values.

The method may comprise storing the compressed set of values to memory.

According to a second aspect of the present invention there is provided a processing system configured to compress a set of values, the processing system comprising: matrix logic configured to determine a matrix comprising the set of values; similarity logic configured to assess a similarity between pairs of rows and/or pairs of columns of the matrix; reordering logic configured to reorder the rows and/or columns of the matrix in dependence on the similarity between the pairs of rows and/or pairs of columns so as to form a plurality of groups of values; and compression logic configured compress at least one group of values of the plurality of groups of values.

According to a further example there is provided a computer-implemented method of compressing a first set of weights of a first layer of a neural network and a second set of weights of a second, subsequent, layer of the neural network, the method comprising: determining a first matrix comprising a first set of values comprising or representing the first set of weights, the one or more rows or columns of the first matrix being representative of the one or more output channels of the first layer and the one or more other of the rows or columns of the first matrix being representative of the one or more input channels of the first layer; determining a second matrix comprising a second set of values comprising or representing the second set of weights, the one or more rows or columns of the second matrix being representative of the one or more output channels of the second layer and the one or more other of the rows or columns of the second matrix being representative of the one or more input channels of the second layer; forming an array by, either: transposing the first matrix and forming the array comprising the transposed first matrix and the second matrix by aligning the columns or rows of the transposed first matrix that are representative of the one or more output channels of the first layer with the columns or rows of the second matrix that are representative of the one or more input channels of the second layer; or transposing the second matrix and forming the array comprising the transposed second matrix and the first matrix by aligning the rows or columns of the transposed second matrix that are representative of the one or more input channels of the second layer with the rows or columns of the first matrix that are representative of the one or more output channels of the first layer; assessing a similarity between pairs of rows and pairs of columns of the array; reordering the rows and columns of the array in dependence on the similarity between the pairs of rows and pairs of columns of the array so as to form a plurality of groups of values of the first set of values and a plurality of groups of values of the second set of values; and compressing at least one group of values of the plurality of groups of values of the first set of values so as to compress the first set of values and/or compressing at least one group of values of the plurality of groups of values of the second set of values so as to compress the second set of values.

The processing system may be embodied in hardware on an integrated circuit. There may be provided a method of manufacturing, at an integrated circuit manufacturing system, the processing system. There may be provided an integrated circuit definition dataset that, when processed in an integrated circuit manufacturing system, configures the system to manufacture the processing system. There may be provided a non-transitory computer readable storage medium having stored thereon a computer readable description of the processing system that, when processed in an integrated circuit manufacturing system, causes the integrated circuit manufacturing system to manufacture an integrated circuit embodying the processing system.

There may be provided an integrated circuit manufacturing system comprising: a non-transitory computer readable storage medium having stored thereon a computer readable description of the processing system; a layout processing system configured to process the computer readable description so as to generate a circuit layout description of an integrated circuit embodying the processing system; and an integrated circuit generation system configured to manufacture the processing system according to the circuit layout description.

There may be provided computer program code for performing any of the methods described herein. There may be provided non-transitory computer readable storage medium having stored thereon computer readable instructions that, when executed at a computer system, cause the computer system to perform any of the methods described herein.

The above features may be combined as appropriate, as would be apparent to a skilled person, and may be combined with any of the aspects of the examples described herein.

BRIEF DESCRIPTION OF THE DRAWINGS

Examples will now be described in detail with reference to the accompanying drawings in which:

Figure 1 shows a processing system configured to compress a set of values.

Figure 2 shows a computer-implemented method of compressing a set of values.

Figure 3 shows a matrix comprising a set of values.

Figure 4 illustrates a partitioned fully-connected graph in dependence on which the rows or columns of a matrix can be reordered.

Figure 5A shows a matrix, the columns of which have been reordered so as to form a plurality of one-dimensional, horizontal, groups of values.

Figure 5B shows a matrix, the rows of which have been reordered so as to form a plurality of one-dimensional, vertical, groups of values.

Figure 5C shows a matrix, the rows and columns of which have been reordered so as to form a plurality of two-dimensional groups of values.

Figure 6 illustrates an example two-dimensional reordering of a matrix.

Figure 7 shows an example neural network.

Figure 8a shows the data structure used in an example convolutional layer.

Figure 8b shows an example convolutional layer.

Figure 9 shows a plurality of two-dimensional planes representing the four-dimensional weights of a convolutional layer of a neural network.

Figure 10 shows a plurality of matrices comprising sets of values comprising or representing sets of weights of a series of adjacent layers of a neural network.

Figure 11A shows an array comprising sets of values comprising or representing sets of weights of a plurality of adjacent fully connected layers of a neural network.

Figure 11B shows an array, the rows and columns of which have been reordered so as to form a plurality of two-dimensional groups of values.

Figure 12 shows a computer system in which the processing system can be implemented; and

Figure 13 shows an integrated circuit manufacturing system for generating an integrated circuit embodying a processing system.

The accompanying drawings illustrate various examples. The skilled person will appreciate that the illustrated element boundaries (e.g., boxes, groups of boxes, or other shapes) in the drawings represent one example of the boundaries. It may be that in some examples, one element may be designed as multiple elements or that multiple elements may be designed as one element. Common reference numerals are used throughout the figures, where appropriate, to indicate similar features.

DETAILED DESCRIPTION

The following description is presented by way of example to enable a person skilled in the art to make and use the invention. The present invention is not limited to the embodiments described herein and various modifications to the disclosed embodiments will be apparent to those skilled in the art.

Embodiments will now be described by way of example only.

There are numerous existing compression schemes that are suitable for compressing a set of values. In one example, a received set of values can be compressed by dividing that set of values into a plurality of groups of values, and independently (e.g. separately) compressing each group of values of the plurality of groups of values. For example, consider a set of 256 values. In raw (e.g. non-compressed) form, each value in the received set of values may be represented using 16 bits. In order to compress that set of values, it may be divided into 32 groups of values, each group of values comprising 8 values of the set of values. Each group of values can be compressed by identifying a sufficient (e.g. the minimum) number of bits required to encode the value having the greatest magnitude in that group of values, and encoding each of the values in that group of values using that number of bits. The bits used to encode each of the values of the group of values can be referred to as "value bits". Data indicating the number of bits used to encode each value of that group of values can itself be encoded by appending one or more additional "header bits" to the data encoding the values of that group of values. These additional header bits can be used during decompression the compressed group of values - e.g. so that the decompression logic can determine which of the value bits relate to each value of the group of values. The set of values can be compressed by repeating this process independently for each group of values of the set of values.

As a worked example, a group of values of a received set of values may comprise the following 8 values: [12, 14, 51, 63, 58, 13, 24, 51]. In raw (e.g. non-compressed) form, each value may be represented using 16 bits, such that a total of 128 bits are required to represent that group of values. The value having the greatest magnitude in that group of values is 63, which can be encoded using 6 bits (e.g. as 1 1 1 1 1 1 in binary). In other words, it can be identified that this number of bits (e.g. 6 bits) is sufficient to (e.g. the minimum number of bits required to) encode the largest value (i.e. 63) in that group of values without loss (e.g. "losslessly"). This means that this number of bits (e.g. 6 bits) will also be sufficient to encode each of the other values (i.e. 12, 14, 51, 58, 13, 24 and 51) in this group of values without loss (e.g. "losslessly"). Therefore, this group of values can be compressed by encoding each of the values in this group of values using 6 bits, such that a total of 48 bits are required to encode the values of that group of values. Data indicating that 6 bits have been used to encode each value of that group of values can itself be encoded by appending additional header bits to the data encoding the values of that group of values. In an example, the number of additional header bits could be the minimum number of bits required to indicate the number of bits (e.g. 6) used per value - e.g. 3 header bits (e.g. as 1 1 0 in binary). In this example, a total of 51 bits (i.e. 48 value bits + 3 header bits) may be required to encode the values of that group of values. In other examples, a fixed number of additional header bits exceeding that minimum number of bits could be used to indicate the number of bits (e.g. 6) used per value - e.g. 5 header bits. In these examples, a total of 53 bits (i.e. 48 value bits + 5 header bits) may be required to encode the values of that group of values. In both cases, a smaller amount of data (e.g. fewer bits of data) are required to represent the compressed group of values (e.g. 51 bits or 53 bits) relative to the received group of values (e.g. 128 bits).

The inventors have realised that the example compression scheme described above can be inefficient when a group of values to be compressed comprises one or more "outlying" values, e.g. one or more values that are significantly larger than the majority of the values in that group of values. This results in the majority of the values in that group of values being encoded using a significantly larger number of bits than the minimum number of bits required to encode those values. For example, consider a group of values comprising the following 8 values: [1, 1, 1, 1, 1, 1, 1, 1]. This group of values does not comprise any "outlying" values. According to the example compression scheme described above, this group of values could be compressed by encoding each of the values in this group of values using 1 bit, such that a total of 8 bits are required to encode the values of that group of values (not including additional header bits, as discussed above). However, consider a group of values comprising the following 8 values: [1, 1, 1, 1, 127, 1, 1, 1]. This group of values comprises an "outlying" value - 127. According to the example compression scheme described above, this group of values could be compressed by encoding each of the values in this group of values using 7 bits, such that a total of 56 bits are required to encode the values of that group of values (not including additional header bits, as discussed above). This is inefficient as the majority of the values in that group of values (which are 1) are being encoded using a significantly larger number of bits (e.g. 7 bits) than the minimum number of bits (e.g. 1 bit) required to encode those values.

Described herein is a method of, and processing system for, compressing a set of values that is intended to address this inefficiency.

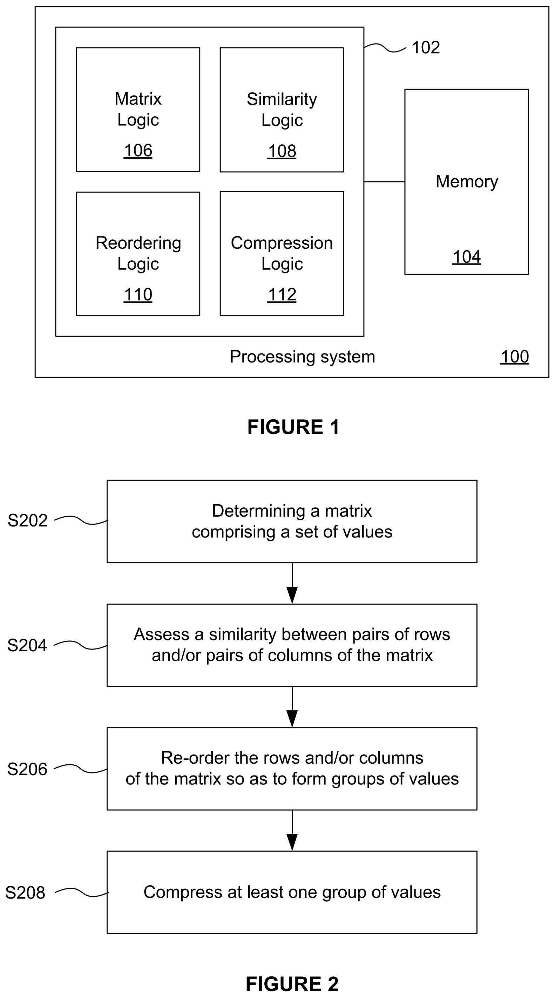

Figure 1 shows a processing system 100 configured to compress a set of values. Processing system 100 comprises processing logic 102. Processing logic 102 comprises matrix logic 106, similarity logic 108, reordering logic 110 and compression logic 112. Each of matrix logic 106, similarity logic 108, reordering logic 110 and compression logic 112 may be implemented in fixed-function hardware, software running at general purpose hardware, or any combination thereof. The functions of each of matrix logic 106, similarity logic 108, reordering logic 110 and compression logic 112 will be described herein in further detail.

Memory 104 is accessible to processing logic 102. Memory 104 may be a system memory accessible to processing logic 102 over a data bus. Processing logic 102 may be implemented on a chip (e.g. semiconductor die and/or integrated circuit package) and memory 104 may not be physically located on the same chip (e.g. semiconductor die and/or integrated circuit package) as processing logic 102. As such, memory 104 may be referred to as "off-chip memory" and/or "external memory". Alternatively, processing logic 102 may be implemented on a chip (e.g. semiconductor die and/or integrated circuit package) and memory 104 may be physically located on the same chip (e.g. semiconductor die and/or integrated circuit package) as processing logic 102. As such, memory 104 may be referred to as "on-chip memory" and/or "local memory". Alternatively again, memory 104 shown in Figure 1 may represent any combination of "on-chip" and "off-chip" memories - e.g. one or more "on-chip" memories and one or more "off-chip" memories arranged in a memory hierarchy.

Memory 104 may store computer executable instructions for performing a method of compressing a set of values in accordance with the principles described herein (e.g. the method that will be described herein with reference to Figure 2). Memory 104 may store a set of values that is received at the processing system 100 for compression. Memory 104 may store a compressed set of values output as a result of performing a method of compressing a set of values in accordance with the principles described herein (e.g. as a result of processing logic 102 executing the computer executable instructions stored by the memory 104). Memory 104 may store that compressed set of values for subsequent use (e.g. by other unshown logic comprised by processing system 100, or by an external system).

Figure 2 shows a computer-implemented method of compressing a set of values. The computer-implemented method of compressing a set of values shown in Figure 2 may be performed by processing system 100 shown in Figure 1.

*Determining a matrix*

In step S202, a matrix comprising a set of values to be compressed is determined. Step S202 may be performed by matrix logic 106. The matrix may be a one-dimensional matrix. That is, the matrix may comprise a plurality of columns and a single row, or a plurality of rows and a single column. Alternatively, the matrix may be a two-dimensional matrix. That is, the matrix may comprise a plurality of columns and a plurality of rows.

Values for compression may be received by matrix logic 106, for example, by being read into matrix logic 106 from memory 104. Those values may have been written into memory 104 by other logic (not shown) comprised by processing system 100, or by an external system. In some examples, the received values may be a set of pixel values representing an image, a set of audio samples representing an audio signal, or weights of a layer of a neural network.

The values received by matrix logic 106 may be arranged in a matrix. For example, as will be described in further detail herein, the weights of a fully connected layer of a neural network are typically arranged in a matrix. As such, in some examples, determining the matrix comprising the set of values may comprise receiving a matrix comprising a plurality of values.

In other examples, determining the matrix comprising the set of values may comprise forming a matrix comprising a plurality of values. For example, as will be described in further detail herein, the weights of a convolutional layer of a neural network are typically arranged in a number of (e.g. $C_{out}$) output channels, each output channel arranged in a number of (e.g. $C_{in}$) input channels, each input channel of each output channel comprising a number of weights. In this example, determining the matrix comprising the set of values may comprise forming one or more planes of weights (e.g. having

dimensions $C_{out} \times C_{in}$) representing those weights, each plane of weights being a formed matrix comprising a plurality of values.

The set of values comprised by the matrix determined in step S202 may comprise a plurality of received values. That is, determining the matrix comprising the set of values may not comprise performing a pre-processing operation on any of the values that are received.

Alternatively, the set of values comprised by the matrix determined in step S202 may comprise a plurality of pre-processed values. That is, determining the matrix comprising the set of values may comprise performing a pre-processing operation on each of a plurality of values that are received so as to generate a plurality of pre-processed values that will be comprised by the set of values. It is to be understood that a set of values that comprises a plurality of pre-processed values generated by performing a pre-processing operation on each of a plurality of received values can be said to represent that plurality of received values.

In an example pre-processing operation, if one or more of the values that are received are negative values represented using two's complement, determining the matrix may optionally comprise folding and interleaving each of the received values so that they are all positive. The folding and interleaving operation performed on each received value can be written mathematically as follows:

$$symbol = \begin{cases} (-2 * coeff) - 1, & coeff < 0 \\ 2 * coeff, & otherwise \end{cases}$$

where *"coeff"* is the received value and *"symbol"* is the pre-processed value. When the received values are represented in two's complement, a multiplication by two can be implemented by left shifting by one bit position, and so this may be implemented in hardware (or software) as:

$$symbol := \text{isignbitset?} \left( ((\text{NOT coeff}) \ll 1) \text{ OR } 1 \right) : \text{coeff} \ll 1;$$

or

$$symbol := \text{isignbitset? NOT} (\text{coeff} \ll 1) : \text{coeff} \ll 1$$

where "NOT" and "OR" are bitwise operators and "« 1" indicates left shifting by one bit position. This essentially converts the received value to a sign magnitude-like format but places the sign bit as the least significant bit. It will therefore be appreciated that if the received values are originally in sign magnitude format, this pre-processing step may be modified such that it comprises moving the sign bit from the most significant bit to the least significant bit.

In another example pre-processing operation, determining the matrix may optionally comprise adding, or subtracting, an offset to, or from, each of the values that are received. The offset could have any suitable magnitude.

In yet another example pre-processing operation, determining the matrix may optionally comprise adding, or subtracting, an offset to, or from, each of the values that are received, and then performing the folding and interleaving operation described above on the offset values (such that *"coeff"* in the equation above is the offset value).

It is to be understood that, when a pre-processing operation is performed during step S202 on values that are received, the inverse operation is applied during decompression of the compressed set of values (as output from step S208, as will be described herein). That is, in examples in which a folding and interleaving operation, and/or an offset addition or subtraction operation, is performed during step S202, the decompression of the compressed set of values (as output from step S208) would comprise an "unfolding" and "de-interleaving" operation, and/or an offset subtraction or addition operation.

The set of values comprised by the matrix determined in step S202 may consist of the plurality of received or pre-processed values (as described above). Alternatively, determining the matrix comprising the set of values may also comprise adding one or more rows or columns of padding values (e.g. "0"s) to a received or formed matrix comprising a plurality of received or pre-processed values - e.g. such that the matrix comprising the set of values to be compressed has predefined dimensions. That is, the set of values comprised by the matrix determined in step S202 may comprise a plurality of received or pre-processed values (as described above), and a plurality of padding values. It is to be understood that a set of values that comprises a plurality of pre-processed values generated by performing a pre-processing operation on each of a plurality of received values, and a plurality of padding values, can be said to represent that plurality of received values. It is also to be understood that, when one or more rows or columns of padding values are added during step S202, said one or more rows or columns of padding values are removed during decompression of the compressed set of values (as output from step S208, as will be described herein).

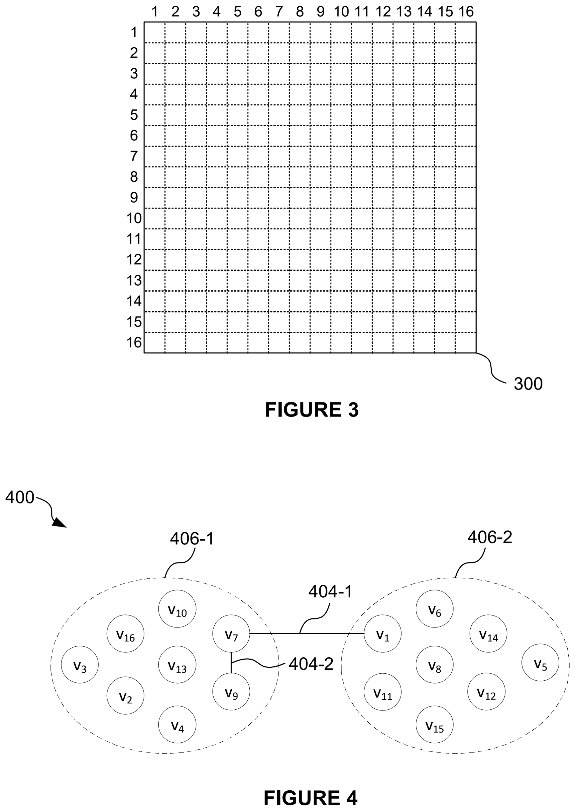

As an illustrative example, Figure 3 shows a matrix 300 comprising a set of values. In the example shown in Figure 3, matrix 300 comprises a set of 256 values, arranged in 16 rows and 16 columns - each labelled 1 to 16 in Figure 3. It is to be understood that a matrix determined in step S202 could have any suitable number of values, arranged in any suitable number of rows and columns. For ease of illustration, the numerical value of each value in the set of values is not shown in Figure 3.

*Assessing a similarity between pairs of rows and/or pairs of columns of the matrix*

In step S204, a similarity between pairs of rows and/or pairs of columns of the matrix is assessed. Step S204 may be performed by similarity logic 108. That is, in step S204: (i) a similarity between pairs of rows of the matrix may be assessed; (ii) a similarity between pairs of columns of the matrix may be assessed; or (iii) a similarity between pairs of rows of the matrix may be assessed, and a similarity between pairs of columns of the matrix may be assessed.

Assessing the similarity between pairs of columns of the matrix may comprise, for each column of the matrix, assessing the similarity between that column of the matrix and, respectively (e.g. separately, or independently), each other column of the matrix. For example, referring to Figure 3 and considering column 1, the similarity between column 1 and, respectively, each of columns 2 to 16 may be assessed. In other words, for the example matrix shown in Figure 3, 15 separate (e.g. independent) similarity assessments may be performed for column 1. Analogous similarity assessments may be performed for each of columns 2 to 16.

Assessing the similarity between the pairs of rows of the matrix may comprise, for each row of the matrix, assessing the similarity between that row of the matrix and, respectively (e.g. separately, or independently), each other row of the matrix. For example, referring to Figure 3 and considering row 1, the similarity between row 1 and, respectively, each of rows 2 to 16 may be assessed. In other words, for the example matrix shown in Figure 3, 15 separate (e.g. independent) similarity assessments may be performed for row 1. Analogous similarity assessments may be performed for each of rows 2 to 16.

Assessing the similarity between a pair of columns (or a pair of rows) of the matrix may comprise assessing the similarity in the values (e.g. the absolute values, or the magnitude of the values) comprised by that pair of columns (or that pair of rows). In some examples, assessing the similarity between a pair of columns (or a pair of rows) of the matrix may comprise determining one or more of an L1 (e.g. Manhattan) distance, an L2 (e.g. Euclidean) distance, a cosine similarity and a Minkowski distance between the values comprised by that pair of columns (or that pair of rows). For example, given a pair of columns (or a pair of rows) p and q, the L1 distance between the values comprised by that pair of columns (or that pair of rows) can be given by $d = \Sigma_i |p_i - q_i|$ where $p_i$ and $q_i$ denote the ith values comprised by each of that pair of columns (or that pair of rows). As a worked example, consider a first column (or row) comprising the values [61, 31, 2, 59] and a second column (or row) comprising the values [9, 47, 53, 29]. The L1 distance between the values comprised by that pair of columns (or that pair of rows) is |61-9| + |31-47| + |2-53| + |59-29| = 149. As would be understood by the skilled person, a higher L1 distance is indicative of lesser similarity, and a lower L1 distance is indicative of greater similarity.

Alternatively, or additionally, assessing the similarity between a pair of columns (or a pair of rows) of the matrix may comprise assessing the similarity in the minimum number of bits required to encode values comprised by that pair of columns (or that pair of rows). In some examples, assessing the similarity between a pair of columns (or a pair of rows) of the matrix may comprise determining one or more of an L1 (e.g. Manhattan) distance, an L2 (e.g. Euclidean) distance, a cosine similarity and a Minkowski distance between the minimum number of bits required to encode values comprised by that pair of columns (or that pair of rows). For example, given a pair of columns (or a pair of rows) p and q, the L1 distance between the minimum number of bits required to encode values comprised by that pair of columns (or that pair of rows) can be given by $d = \Sigma_i |p_i - q_i|$ where $p_i$ and $q_i$ denote the minimum number of bits required to encode the ith values comprised by each of that pair of columns (or that pair of rows). As a worked example, consider a first column (or row) comprising the values [61, 31, 2, 59] and a second column (or row) comprising the values [9, 47, 53, 29]. The minimum number of bits required to encode the values comprised the first column (or row) is, respectively, 6 bits, 5 bits, 2 bits and 6 bits. The minimum number of bits required to encode the values comprised the second column (or row) is, respectively, 4 bits, 6 bits, 6 bits and 5 bits. The L1 distance between the minimum number of bits required to encode values comprised by that pair of columns (or that pair of rows) is |6-4| + |5-6| + |2-6| + |6-5| = 8. As would be understood by the skilled person, a higher L1 distance is indicative of lesser similarity, and a lower L1 distance is indicative of greater similarity.

*Reordering the rows and/or columns of the matrix*

In step S206, the rows and/or columns of the matrix are reordered (e.g. rearranged or permuted) in dependence on the similarity between pairs of rows and/or pairs of columns as assessed in step S204. Step S206 is performed so as to form a plurality of groups of values of the set of values. Step S206 may be performed by reordering logic 110. That is, in step S206: (i) the rows of the matrix may be reordered; (ii) the columns of the matrix may be reordered; or (iii) the rows of the matrix may be reordered, and the columns of the matrix may be reordered.

In step S206, the rows and/or columns of the matrix may be reordered so as to form a plurality of groups of similar values. Put another way, in step S206, the rows and/or columns of the matrix may be reordered so as to form a plurality of groups of values in which values of the set of values having greater similarity (e.g. "similar values") are preferentially grouped together and in which values of the set of values having lesser similarity (e.g. "dissimilar values") are preferentially separated into different groups of the plurality of groups of values. It is to be understood that the term "preferentially" is used here because, in practice, it may not be possible to "perfectly" form a plurality of groups of values in which none of those groups of values comprise an "outlying" value. In other words, step S206 may be performed so as to minimise the number of groups of values to be compressed that comprise one or more "outlying" values, e.g. one or more values that are significantly larger than the majority of the values in that group of values. Put another way, step S206 may be performed so as to reduce the number of groups of values to be compressed that comprise one or more "outlying" values, relative to if the set of values were to have been divided into a plurality of groups of values (of the same dimensions) before reordering the rows and/or columns of the matrix. Put yet another way, step S206 may be performed so as to increase the number of groups of values to be compressed in which each of the values within a group of values could be assessed to determine the minimum number of bits required to encode that value and the minimum number of bits required to encode each value in that group of values would be the same, relative to if the set of values were to have been divided into a plurality of groups of values (of the same dimensions) before reordering the rows and/or columns of the matrix. Put another way, step S206 may be performed so as to reduce the average difference between the largest and smallest values within each group of values of the plurality of groups of values, relative to if the set of values were to have been divided into a plurality of groups of values (of the same dimensions) before reordering the rows and/or columns of the matrix. The largest and smallest values in a group of values may be those values having, respectively, the largest and smallest absolute value, or largest and smallest magnitude. For example, the difference between the largest (8) and smallest (1) values of the group of values [1, 1, 8, 1] is 7 (8-1). The average difference could be determined by determining a respective difference for each group of values of the plurality of groups of values, and calculating an average (e.g. mean) of those respective differences. Put another way, step S206 may be performed so as to reduce the average difference between the minimum number of bits required to encode the largest value and the minimum number of bits required to encode the smallest value within each group of values of the plurality of groups of values, relative to if the set of values were to have been divided into a plurality of groups of values (of the same dimensions) before reordering the rows and/or columns of the matrix. The largest and smallest values in a group of values may be those values having, respectively, the largest and smallest absolute value, or largest and smallest magnitude. For example, the difference between the minimum number of bits required to encode the largest (8, 4 bits) and smallest (1, 1 bit) values of the group of values [1, 1, 8, 1] is 3 (4-1). The average difference could be determined by determining a respective difference for each group of values of the plurality of groups of values, and calculating an average (e.g. mean) of those respective differences.

Each of the plurality of groups of values may comprise a plurality of values of the set of values. Said plurality of values may be contiguous within the matrix. Each of the plurality of groups of values may be one-dimensional. That is, each of the plurality of groups of values may comprise a plurality of columns and a single row, or a plurality of rows and a single column. Alternatively, each of the plurality of groups of values may be two-dimensional. That is, each of the plurality of groups of values may comprise a plurality of columns and a plurality of rows. Each of the plurality of groups of values may comprise a predetermined number of values of the set of values. Each of the plurality of groups of values may comprise the same number of values. For example, each of the plurality of values may comprise 8 values of the set of values - or any other suitable number of values of the set of values. Each of the values of the set of values may be comprised by a group of values of the plurality of group of values.

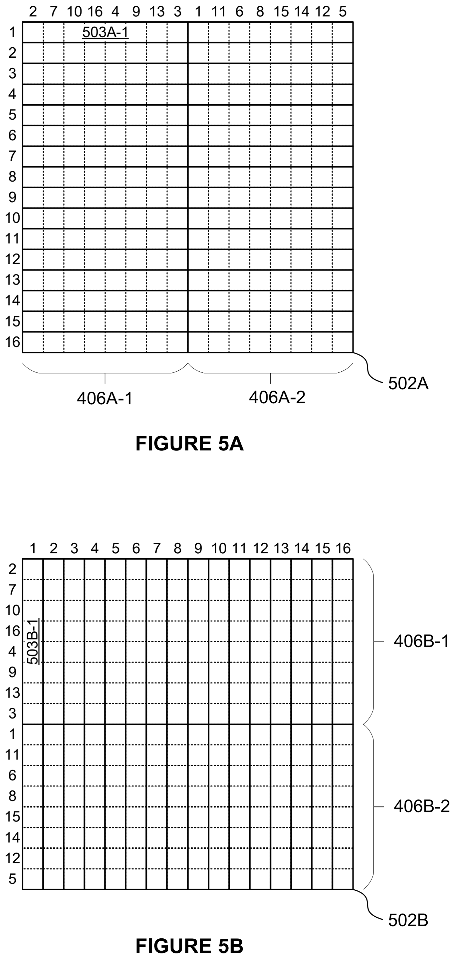

In a first example of step S206, the columns of the matrix can be reordered in dependence on the similarity between pairs of columns (as assessed in step S204) so as to form a plurality of one-dimensional, horizontal, groups of values. This may be referred to as a one-dimensional reordering of the matrix. As an illustrative example, Figure 5A shows a matrix 502A, the columns of which have been reordered so as to form a plurality of one-dimensional, horizontal, groups of values. Relative to Figure 3, in Figure 5A the 16 columns of matrix 502A are in a different order - i.e. 2, 7, 10, 16, 4, 9, 13, 3, 1, 11, 6, 8, 15, 14, 12, 5 in Figure 5A rather than 1 to 16 in Figure 3. Note that the rows of matrix 502A have not been reordered - that is, the 16 rows of matrix 502A are in the same order as the 16 rows of matrix 300. In order to form the plurality of one-dimensional, horizontal, groups of values, the columns of the matrix may be reordered so as to form a plurality of groups of columns in which pairs of columns having greater similarity (e.g. "similar columns") are preferentially grouped together and in which pairs of columns having lesser similarity (e.g. dissimilar columns) are preferentially separated into different groups of the plurality of groups of columns. It is to be understood that the term "preferentially" is used here because, in practice, it may not be possible to "perfectly" group similar columns together and "perfectly" separate dissimilar columns. That is, in practice, some similar columns may be separated into different groups of columns, and/or some dissimilar columns may be grouped together. Each of the groups of columns may comprise a respective plurality of columns of the matrix that are contiguous in the matrix once the columns of the matrix have been reordered. The values in each row of each group of columns may form a one-dimensional, horizontal, group of values. Reordering the columns of the matrix in this way can have the effect of reducing the number of one-dimensional, horizontal, groups of values to be compressed that comprise one or more "outlying" values, relative to if the set of values were to have been divided into a plurality of groups of values (of the same dimensions) before reordering the columns of the matrix. Reordering the columns of the matrix in this way can have the effect of increasing the number of one-dimensional, horizontal, groups of values to be compressed in which each of the values within a group of values could be assessed to determine the minimum number of bits required to encode that value and the minimum number of bits required to encode each value in a group of values would be the same, relative to if the set of values were to have been divided into a plurality of groups of values (of the same dimensions) before reordering the columns of the matrix. Reordering the columns of the matrix in this way can have the effect of reducing the average difference between the largest and smallest values within each one-dimensional, horizontal, group of values of the plurality of one-dimensional, horizontal, groups of values, relative to if the set of values were to have been divided into a plurality of one-dimensional, horizontal, groups of values (of the same dimensions) before reordering the columns of the matrix. Reordering the columns of the matrix in this way can have the effect of reducing the average difference between the minimum number of bits required to encode the largest value and the minimum number of bits required to encode the smallest value within each one-dimensional, horizontal, group of values of the plurality of one-dimensional, horizontal, groups of values, relative to if the set of values were to have been divided into a plurality of one-dimensional, horizontal, groups of values (of the same dimensions) before reordering the columns of the matrix. As an illustrative example, Figure 5A illustrates a first group of columns 406A-1 (including columns 2, 7, 10, 16, 4, 9, 13 and 3) and a second group of columns 406A-2 (including columns 1, 11, 6, 8, 15, 14, 12, 5). It is to be understood that, in other examples, the columns of the matrix could be reordered to form more than two groups of columns. The 8 values in row 1 of the first group of columns 406A-1 forms one-dimensional, horizontal, group of values 503A-1. In Figure 5A, the columns of the matrix have been reordered so as to form 32 one-dimensional, horizontal, groups of values. These are illustrated using solid borders in Figure 5A. The one-dimensional, horizontal, groups of values other than 503A-1 are not labelled for ease of illustration. In Figure 5A, each of the one-dimensional, horizontal, groups of values comprises 8 values of the set of values.

In a second example of step S206, the rows of the matrix can be reordered in dependence on the similarity between pairs of rows (as assessed in step S204) so as to form a plurality of one-dimensional, vertical, groups of values. This may be referred to as a one-dimensional reordering of the matrix. As an illustrative example, Figure 5B shows a matrix 502B, the rows of which have been reordered so as to form a plurality of one-dimensional, vertical, groups of values. Relative to Figure 3, in Figure 5B the 16 rows of matrix 502B are in a different order - i.e. 2, 7, 10, 16, 4, 9, 13, 3, 1, 11, 6, 8, 15, 14, 12, 5 in Figure 5B rather than 1 to 16 in Figure 3. Note that the columns of matrix 502B have not been reordered - that is, the 16 columns of matrix 502B are in the same order as the 16 columns of matrix 300. In order to form the plurality of one-dimensional, vertical, groups of values, the rows of the matrix may be reordered so as to form a plurality of groups of rows in which pairs of rows having greater similarity (e.g. "similar rows") are preferentially grouped together and in which pairs of rows having lesser similarity (e.g. dissimilar rows) are preferentially separated into different groups of the plurality of groups of rows. It is to be understood that the term "preferentially" is used here because, in practice, it may not be possible to "perfectly" group similar rows together and "perfectly" separate dissimilar rows. That is, in practice, some similar rows may be separated into different groups of rows, and/or some dissimilar rows may be grouped together. Each of the groups of rows may comprise a respective plurality of rows of the matrix that are contiguous in the matrix once the rows of the matrix have been reordered. The values in each column of each group of rows may form a one-dimensional, vertical, group of values. Reordering the rows of the matrix in this way can have the effect of reducing the number of one-dimensional, vertical, groups of values to be compressed that comprise one or more "outlying" values, relative to if the set of values were to have been divided into a plurality of groups of values (of the same dimensions) before reordering the rows of the matrix. Reordering the rows of the matrix in this way can have the effect of increasing the number of one-dimensional, vertical, groups of values to be compressed in which each of the values within a group of values could be assessed to determine the minimum number of bits required to encode that value and the minimum number of bits required to encode each value in a group of values would be the same, relative to if the set of values were to have been divided into a plurality of groups of values (of the same dimensions) before reordering the rows of the matrix. Reordering the rows of the matrix in this way can have the effect of reducing the average difference between the largest and smallest values within each one-dimensional, vertical, group of values of the plurality of one-dimensional, vertical, groups of values, relative to if the set of values were to have been divided into a plurality of one-dimensional, vertical, groups of values (of the same dimensions) before reordering the rows of the matrix. Reordering the rows of the matrix in this way can have the effect of reducing the average difference between the minimum number of bits required to encode the largest value and the minimum number of bits required to encode the smallest value within each one-dimensional, vertical, group of values of the plurality of one-dimensional, vertical, groups of values, relative to if the set of values were to have been divided into a plurality of one-dimensional, vertical, groups of values (of the same dimensions) before reordering the rows of the matrix. As an illustrative example, Figure 5B illustrates a first group of rows 406B-1 (including rows 2, 7, 10, 16, 4, 9, 13 and 3) and a second group of rows 406B-2 (including rows 1, 11, 6, 8, 15, 14, 12, 5). It is to be understood that, in other examples, the rows of the matrix could be reordered to form more than two groups of rows. The 8 values in column 1 of the first group of rows 406B-1 forms one-dimensional, vertical, group of values 503B-1. In Figure 5B, the rows of the matrix have been reordered so as to form 32 one-dimensional, vertical, groups of values. These are illustrated using solid borders in Figure 5B. The one-dimensional, vertical, groups of values other than 503B-1 are not labelled for ease of illustration. In Figure 5B, each of the one-dimensional, vertical, groups of values comprises 8 values of the set of values.

In one specific example, a one-dimensional reordering of the matrix (e.g. as illustrated in Figure 5A or 5B) can be performed by forming a fully-connected graph representing the matrix and using a graph partitioning algorithm to partition that graph. A fully-connected graph is a graph in which each vertex is connected to all of the other vertices by respective edges. By way of example, so as to reorder the columns of the matrix, a fully-connected graph can be formed in which each vertex represents a column of the matrix, and each edge is associated with a cost that depends on the similarity (e.g. as assessed in step S204) between the pair of columns represented by the vertices connected by that edge. In an example, the cost associated with each edge may be equal to, or proportional to, the similarity (e.g. as assessed in step S204) between the pair of columns represented by the vertices connected by that edge. For example, vertices representing pairs of columns having greater similarity (e.g. lower L1 distance) can be connected by edges associated with lower costs. In an alternative example, the cost associated with each edge may be inversely proportional to the similarity (e.g. as assessed in step S204) between the pair of columns represented by the vertices connected by that edge. For example, vertices representing pairs of columns having greater similarity (e.g. lower L1 distance) can alternatively be connected by edges associated with higher costs. A graph partitioning algorithm can be used to partition the fully-connected graph into a plurality of parts in dependence on the costs associated with the edges, each part including a plurality of vertices representing a plurality of columns that will be grouped together in a respective group of columns when the columns of the matrix are reordered. In examples where vertices representing pairs of columns having greater similarity are connected by edges associated with lower costs, the graph partitioning algorithm may be configured to minimise the total cost of the edges connecting vertices within the same partition. In alternative examples where vertices representing pairs of columns having greater similarity are connected by edges associated with higher costs, the graph partitioning algorithm may be configured to minimise the total cost of the edges connecting vertices within different partitions.

It is to be understood that the rows of the matrix can be reordered in an analogous way - e.g. by using a graph partitioning algorithm as described herein to partition a fully-connected graph in which each vertex represents a row of the matrix, and each edge is associated with a cost that depends on the similarity (e.g. as assessed in step S204) between the pair of rows represented by the vertices connected by that edge.

As an illustrative example, Figure 4 shows a partitioned fully-connected graph 400 in dependence on which the columns or rows of matrix 300 shown in Figure 3 can be reordered. Figure 4 shows 16 vertices, labelled $v_1$ to $v_{16}$, representing the 16 columns (or 16 rows) of the matrix 300. Figure 4 also illustrates two edges - labelled 404-1 and 404-2. Edge 404-1 connects the vertices $v_1$ and $v_7$ representing, respectively, columns (or rows) 1 and 7. Edge 404-1 can be associated with a cost that depends on the similarity (e.g. as assessed in step S204) between columns (or rows) 1 and 7. Edge 404-2 connects the vertices $v_7$ and $v_9$ representing, respectively, columns (or rows) 7 and 9. Edge 404-2 can be associated with a cost that depends on the similarity (e.g. as assessed in step S204) between columns (or rows) 7 and 9. As described herein, a fully-connected graph is a graph in which each vertex is connected to all of the other vertices by respective edges. The edges, other than edges 404-1 and 404-2, connecting the vertices of fully-connected graph 400 are not shown in Figure 4 for ease of illustration. In Figure 4, the fully-connected graph has been partitioned into two parts, labelled 406-1 and 406-2, e.g. using a graph partitioning algorithm as described herein. Edge 404-1 is an edge that connects vertices within different partitions. Edge 404-2 is an edge that connects vertices within the same partition. Part 406-1 includes vertices representing columns (or rows) 2, 7, 10, 16, 4, 9, 13 and 3. Part 406-2 includes vertices representing columns (or rows) 1, 11, 6, 8, 15, 14, 12, 5. As shown in Figure 5A, when the columns of the matrix are reordered in dependence on partitioned fully-connected graph 400, the columns represented by vertices in part 406-1 can be grouped in first group of columns 406A-1, and the columns represented by vertices in part 406-2 can be grouped in second group of columns 406A-2. As shown in Figure 5B, when the rows of the matrix are reordered in dependence on partitioned fully-connected graph 400, the rows represented by vertices in part 406-1 can be grouped in first group of rows 406B-1, and the rows represented by vertices in part 406-2 can be grouped in second group of rows 406B-2.

Put another way, $G = (V, E)$ can represent a graph where each $v_i \in V$ represents the ith column (or row) of a given matrix M comprising a set of values to be compressed. The graph G is fully connected, and hence there exists an edge $e_{ij}$ between each vertex $v_i$ and $v_j$. Each edge can be associated with a cost $c_{ij}$ that depends on the similarity between the pair of columns (or rows) represented by the vertices connected by that edge. For example, a cost $c_{ij}$ can be computed as follows. As described herein, given two column (or row) vectors p and q, in step S204, the distance between the two vectors in $L_1$ space can be given by $d = \Sigma_i |p_i - q_i|$ where $p_i$ and $q_i$ denote ith component of both vectors. That is, the distance can be calculated as the sum of absolute values of element-wise differences. After computing an L1 distance $d_{ij}$ between every pair of ith and jth columns (or rows) in the matrix M, all these computed L1 distances can be sorted (e.g. in descending order, i.e. largest to smallest) in a sorted array. The cost $c_{ij}$ associated with the edge between vertices $v_i$ and $v_j$ can be set to the index (e.g. indicating the position) of the L1 distance computed for that pair of vertices within the sorted array. The reason that, in this very specific example, vertices representing pairs of columns (or rows) with greater similarity are assigned higher costs is because the graph partitioning algorithm can be configured to minimise the cost of edges crossing different cuts (e.g. connecting vertices within different parts), meaning that pairs of columns (or rows) represented by vertices assigned higher costs (e.g. greater similarity) are weighted towards being placed together in the same part when the graph is partitioned. This can be achieved by partitioning the vertices $V$ into $k$ disjoint subsets $V_1, V_2, ... , V_k$, where $V_1 \cup$

$V_2 \cup ... \cup V_k = V$ and $V_i \cap V_j = \emptyset$ for $i \neq j$. This partitioning can be performed in order to minimise the total cost of edges connecting vertices in different partitions. This objective can be expressed as follows:

$$Minimize \sum_{\substack{e=(u,v) \in E \\ u \in V_i, v \in V_j, i \neq j}} w(e)$$

where $E$ is the set of edges and $w(e)$ represents the costs of the edge $e \in E$.

In order to ensure that each partition has roughly the same size, a balance constraint can be implemented. The balance constraint me be expressed as, either: $|V_i| \approx |V_j| \; \forall i,j$ or $V_i \leq (1 + \epsilon) \left\lceil \frac{|V|}{k} \right\rceil$ .

As shown in the specific example described above, a one-dimensional reordering of the matrix (e.g. as illustrated in Figure 5A or 5B) can be performed using a graph partitioning algorithm. It is to be understood that a one-dimensional reordering of the matrix (e.g. as illustrated in Figure 5A or 5B) can alternatively be performed in numerous different ways. As would be understood by the skilled person, a graph partitioning problem can also be equivalently modelled as a hypergraph partitioning problem. Alternatively, the problem can be formulated as an Integer Programming issue, which can be solved using various optimization methods such as Branch and Bound, Dynamic Programming, Monte Carlo-based randomized algorithms, and metaheuristic algorithms like Simulated Annealing and Genetic Algorithms. Additionally, there are commercial Integer Programming solvers available, such as IBM ILOG CPLEX and Gurobi.

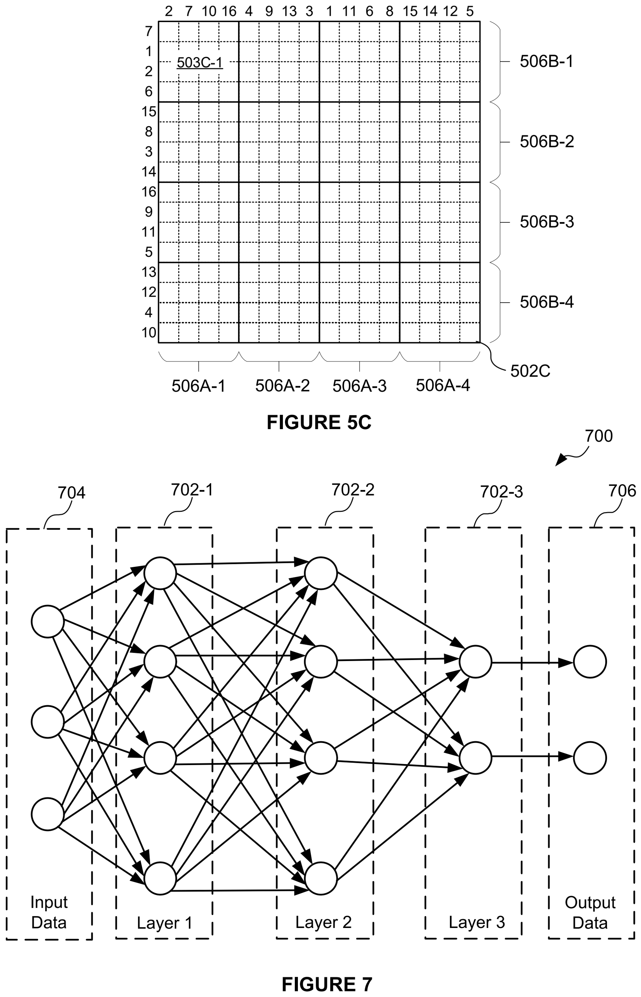

In a third example of step S206, the columns of the matrix can be reordered in dependence on the similarity (as assessed in step S204) between the pairs of columns, and the rows of the matrix can be reordered in dependence on the similarity (as assessed in step S204) between the pairs of rows, so as to form a plurality of two-dimensional groups of values. This may be referred to as a two-dimensional reordering of the matrix. As an illustrative example, Figure 5C shows a matrix 502C, the columns and rows of which have been reordered so as to form a plurality of two-dimensional groups of values. Relative to Figure 3, in Figure 5C the 16 columns of matrix 502C are in a different order - i.e. 2, 7, 10, 16, 4, 9, 13, 3, 1, 11, 6, 8, 15, 14, 12, 5 in Figure 5C rather than 1 to 16 in Figure 3. Relative to Figure 3, in Figure 5C the 16 rows of matrix 502C are also in a different order - i.e. 7, 1, 2, 6, 15, 8, 3, 14, 16, 9, 11, 5, 13, 12, 4, 10 in Figure 5C rather than 1 to 16 in Figure 3. In order to form the plurality of two-dimensional groups of values: the columns of the matrix may be reordered so as to form a plurality of groups of columns in which pairs of columns having greater similarity (e.g. "similar columns") are preferentially grouped together and in which pairs of columns having lesser similarity (e.g. dissimilar columns) are preferentially separated into different groups of the plurality of groups of columns; and, independently (e.g. separately), the rows of the matrix may be reordered so as to form a plurality of groups of rows in which pairs of rows having greater similarity (e.g. "similar rows") are preferentially grouped together and in which pairs of rows having lesser similarity (e.g. dissimilar rows) are preferentially separated into different groups of the plurality of groups of rows. Each of the groups of columns may comprise a respective plurality of columns of the matrix that are contiguous in the matrix once the columns of the matrix have been reordered. Each of the groups of rows may comprise a respective plurality of rows of the matrix that are contiguous in the matrix once the rows of the matrix have been reordered. The values in each group of columns of each group of rows may form a two-dimensional group of values. Reordering the columns and rows of the matrix in this way can have the effect of reducing the number of two-dimensional groups of values to be compressed that comprise one or more "outlying" values, relative to if the set of values were to have been divided into a plurality of groups of values (of the same dimensions) before reordering the columns and rows of the matrix. Reordering the columns and rows of the matrix in this way can have the effect of increasing the number of two-dimensional groups of values to be compressed in which each of the values within a group of values could be assessed to determine the minimum number of bits required to encode that value and the minimum number of bits required to encode each value in a group of values would be the same, relative to if the set of values were to have been divided into a plurality of groups of values (of the same dimensions) before reordering the columns and rows of the matrix. Reordering the columns and rows of the matrix in this way can have the effect of reducing the average difference between the largest and smallest values within each two-dimensional group of values of the plurality of two-dimensional groups of values, relative to if the set of values were to have been divided into a plurality of two-dimensional groups of values (of the same dimensions) before reordering the columns and rows of the matrix. Reordering the columns and rows of the matrix in this way can have the effect of reducing the average difference between the minimum number of bits required to encode the largest value and the minimum number of bits required to encode the smallest value within each two-dimensional group of values of the plurality of two-dimensional groups of values, relative to if the set of values were to have been divided into a plurality of on two-dimensional groups of values (of the same dimensions) before reordering the columns and rows of the matrix. As an illustrative example, Figure 5C illustrates a first group of columns 506A-1 (including columns 2, 7, 10 and 16), a second group of columns 506A-2 (including columns 4, 9, 13 and 3), a third group of columns 506A-3 (including columns 1, 11, 6 and 8) and a fourth group of columns 506A-4 (including columns 15, 14, 12 and 5). Figure 5C also illustrates a first group of rows 506B-1 (including rows 7, 1, 2 and 6), a second group of rows 506B-2 (including rows 15, 8, 3 and 14), a third group of rows 506B-3 (including rows 16, 9, 11 and 5) and a fourth group of rows 506B-4 (including rows 13, 12, 4 and 10). It is to be understood that, in other examples, the columns of the matrix could be reordered to form more or fewer than four groups of columns, and/or the rows of the matrix could be reordered to form more or fewer than four groups of rows. The 16 values in the first group of columns 506A-1 of the first group of rows 506B-1 forms two-dimensional group of values 503C-1. In Figure 5C, the columns and rows of the matrix have been reordered so as to form 16 two-dimensional groups of values. These are illustrated using solid borders in Figure 5C. The two-dimensional groups of values other than 503C-1 are not labelled for ease of illustration. In Figure 5C, each of the two-dimensional groups of values comprises 16 values of the set of values - although it is to be understood that a two-dimensional group of values could comprise any suitable number of values of the set of values. In Figure 5C, each of the two-dimensional groups of values comprises the same number of columns as rows (e.g. is symmetrical) - although it is to be understood that a two-dimensional group of values need not comprise the same number of columns as rows.

To perform a two-dimensional reordering of the matrix (e.g. as illustrated in Figure 5C), the columns and rows of the matrix can be reordered independently (e.g. separately). In particular, to perform a two-dimensional reordering of the matrix: the columns of the matrix can be reordered by performing a one-dimensional reordering of the matrix as described herein (e.g. by using a graph partitioning algorithm as described herein to partition a fully-connected graph in which each vertex represents a column of the matrix); and, independently, the rows of the matrix can be reordered by performing a one-dimensional reordering of the matrix as described herein (e.g. by using a graph partitioning algorithm as described herein to partition a fully-connected graph in which each vertex represents a row of the matrix). As these two one-dimensional reordering processes can be performed independently, the columns and rows of the matrix can be reordered in parallel. Alternatively, the columns of the matrix could be reordered followed by the rows of the matrix, or vice versa.

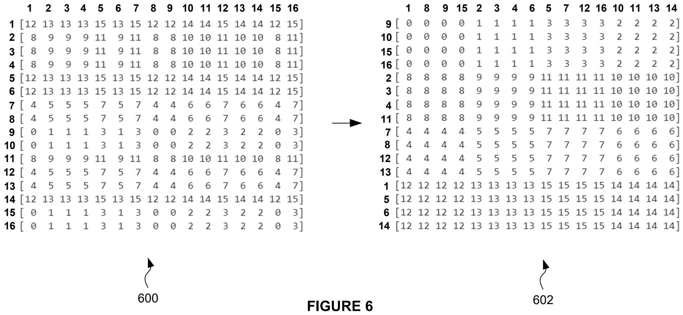

To aid the reader's understanding, Figure 6 illustrates an example two-dimensional reordering of a matrix as described herein. Figure 6 shows matrix 600 comprising a set of values arranged in 16 rows and 16 columns - each labelled 1 to 16 (in bold text). The numerical value of each value in the set of values is shown (not in bold text). Figure 6 also shows matrix 602 comprising the same set of values, the rows and columns of which have been reordered so as to form a plurality of two-dimensional groups of values. That is, the matrix 602 can be formed by reordering the rows and columns of matrix 600 according to the principles described herein with reference to the third example of step S206. In particular, relative to matrix 600, the 16 columns of matrix 602 are in a different order - i.e. 1, 8, 9, 15, 2, 3, 4, 6, 5, 7, 12, 16, 10, 11, 13, 14 in matrix 602 rather than 1 to 16 in matrix 600. Relative to matrix 600, the 16 rows of matrix 602 are also in a different order - i.e. 9, 10, 15, 16, 2, 3, 4, 11, 7, 8, 12, 13, 1, 5, 6, 14 in matrix 602 rather than 1 to 16 in matrix 602. The plurality of two-dimensional groups of values formed in matrix 602 comprises: a group of 16 values comprising exclusively 0s; a group of 16 values comprising exclusively 1s; a group of 16 values comprising exclusively 2s; a group of 16 values comprising exclusively 3s; a group of 16 values comprising exclusively 4s; a group of 16 values comprising exclusively 5s; a group of 16 values comprising exclusively 6s; a group of 16 values comprising exclusively 7s; a group of 16 values comprising exclusively 8s; a group of 16 values comprising exclusively 9s; a group of 16 values comprising exclusively 10s; a group of 16 values comprising exclusively 11s; a group of 16 values comprising exclusively 12s; a group of 16 values comprising exclusively 13s; a group of 16 values comprising exclusively 14s; and a group of 16 values comprising exclusively 15s. Put another way, the plurality of two-dimensional groups of values formed in matrix 602 do not comprise any groups of values that comprise an "outlying" value, e.g. one or more values that are significantly larger than the majority of the values in that group of values.

*Compressing the set of values*

In step S208, at least one group of values of the plurality of groups of values (as formed in step S206) is compressed so as to compress the set of values. Step S208 may be performed by compression logic 112. The set of values can be compressed by independently (e.g. separately) compressing each group of values of the plurality of groups of values (as formed in step S206). The set of values can be losslessly compressed.

In the following, three different compression schemes suitable for compressing (e.g. losslessly compressing) a group of values are described. Compressing a group of values according to any of the three compression schemes described herein comprises: determining a plurality of encodable values in dependence on the group of values, identifying a sufficient (e.g. the minimum) number of bits required to encode the encodable value of the plurality of encodable values that has the greatest magnitude, and encoding each of the encodable values of the plurality of encodable values using that number of bits. As will be described herein, an encodable value can be a value comprised by the group of values, or a difference between two values derived from (e.g. comprised by) the group of values. Each of the three compression schemes described herein is a lossless compression scheme. It is to be understood that these three compression schemes are being described as examples, and that other suitable compression schemes (e.g. lossless compression schemes) could alternatively be used.

Each group of values of the plurality of groups of values (as formed in step S206) may be compressed using the same compression scheme. Alternatively, different groups of values of the plurality of groups of values (as formed in step S206) may be compressed using different compression schemes - e.g. in dependence on which of the available compression schemes can encode that group of values using the fewest number of bits. In other words, step S208 may further comprise, for each of one or more groups of values to be compressed, assessing the number of bits that would be required to encode that group of values according to two or more of the first compression scheme, the second compression scheme and the third compression scheme (as will be described herein), and compressing that group of values according to the compression scheme of the assessed compression schemes that will require the fewest number of bits to encode that group of values. In these examples, data (e.g. a "flag") indicating which compression scheme has been used to compress a group of values may be associated with that compressed group of values. This data can be used during decompression of the compressed group of values - e.g. so that the decompression logic can determine how to interpret the bits encoding the compressed group of values. In some examples, one or more groups of values of the plurality of groups of values may not be compressed. For example, it may be determined that none of the available compression schemes reduce the number of bits required to represent a particular group of values, in which case that group of values may be stored in its raw (e.g. non-compressed) form. As such, a set of values that is compressed according to the principles described herein may comprise: one or more groups of values compressed according to the first compression scheme, one or more groups of values compressed according to the second compression scheme, one or more groups of values compressed according to the third compression scheme, and/or one or more groups of values compressed according to any other suitable compression scheme; and, optionally, one or more groups of values that have not been compressed.

*First compression scheme*

One or more groups of values of the plurality of groups of values (as formed in step S206) can be compressed according to a first compression scheme in which, for each of said one or more groups of values, each value of that group of values is encoded using a number of bits sufficient to represent the value in that group of values that has the greatest magnitude. That is, a group of values can be compressed by identifying a sufficient (e.g. the minimum) number of bits required to encode the value in that group of values that has the greatest magnitude, and encoding each of the values in that group of values using that number of bits. In other words, the same number of bits can be used to encode each of the values of the group of values. It is to be understood that, in groups of values including one or more negative values, each of the values in the group may be encoded using signed binary (e.g. two's complement) - and the use of signed binary would be taken into account when determining the minimum number of bits required to encode the value in that group of values that has the greatest magnitude. It is also to be understood that most, although not all, of the advantages of the principles described herein would still be realised if a sufficient number of bits were identified that exceeded the minimum number of bits required by a small number of bits (e.g. by 1 to 3 bits). The bits used to encode each of the values of the group of values can be referred to as "value bits". Data indicating the number of bits used to encode each value of that group of values can itself be encoded by appending one or more additional "header bits" to the data encoding the values of that group of values. These additional header bits can be used during decompression of the compressed group of values - e.g. so that the decompression logic can determine which of the value bits relate to each value of the group of values.

It is to be understood that, in some examples, according to the first compression scheme, a sufficient (e.g. the minimum) number of bits required to encode a value of 0 may be 0 bits of data (e.g. "no data"), such that each of the values in a group of values comprising exclusively zero values could be encoded with 0 bits of data. In other words, in this special case, the compressed group of values may not comprise any "value bits". Data indicating that 0 bits of data have been used to encode each value of that group of values can be encoded using one or more "header bits". For example, one header bit (e.g. a "0" bit) may be used to indicate that 0 bits of data have been used to encode each value of that group of values.

As a worked example, a group of values (as formed in step S206) may comprise the following 8 values: [1, 2, 1, 1, 2, 0, 1, 1]. In raw (e.g. non-compressed) form, each value may be represented using 16 bits, such that a total of 128 bits are required to represent that group of values.

The value in that group of values that has the greatest magnitude is 2, which can be encoded using 2 bits (e.g. as 1 0 in binary). In other words, it can be identified that this number of bits (e.g. 2 bits) is sufficient to (e.g. the minimum number of bits required to) encode the largest value (i.e. 2) in that group of values without loss (e.g. "losslessly"). This means that this number of bits (e.g. 2 bits) will also be sufficient to encode each of the other values (i.e. 1, 1, 1, 2, 0, 1, 1) in this group of values without loss (e.g. "losslessly"). Therefore, this group of values can be compressed by encoding each of the values in this group of values using 2 bits, such that a total of 16 bits are required to encode the values of that group of values. Data indicating that 2 bits have been used to encode each value of that group of values can itself be encoded by appending additional header bits to the data encoding the values of that group of values. In an example, the number of additional header bits could be the minimum number of bits required to indicate the number of bits (e.g. 2) used per value - e.g. 2 header bits (e.g. as 1 0 in binary). In this example, a total of 18 bits (i.e. 16 value bits + 2 header bits) may be required to encode the values of that group of values. In other examples, a fixed number of additional header bits exceeding that minimum number of bits could be used to indicate the number of bits (e.g. 2) used per value - e.g. 5 header bits. In these examples, a total of 21 bits (i.e. 16 value bits + 5 header bits) may be required to encode the values of that group of values.

In both cases, a smaller amount of data (e.g. fewer bits of data) are required to represent the compressed group of values (e.g. 18 bits or 21 bits) relative to the group of values in its raw (e.g. non-compressed) form (e.g. 128 bits).

The first compression scheme described herein is particularly efficient for compressing groups of values (as formed in step S206) that include a plurality of values having a small magnitude (e.g. for which the minimum number of bits required to encode those values is small) and no "outlying" values e.g. one or more values that are significantly larger than the majority of the values in that group of values.

*Second compression scheme*

One or more groups of values of the plurality of groups of values (as formed in step S206) can be compressed according to a second compression scheme in which, for each of said one or more groups of values, a base value is determined in dependence on the values of that group of values. Determining the base value could comprise determining the minimum value, the maximum value, the median value, the mode value, or the mean of that group of values, or a value within a predetermined position within the group of values, to be the base value - although it is to be understood that any other suitable base value could alternatively be determined. The minimum value may be the value having the smallest absolute value. The maximum value may be the value having the largest absolute value. For each of one or more values of that group of values, a respective difference between that value and the base value can be determined. Each determined difference could be positive or negative. Note that, in some examples, by exploiting the "wrap around" property of modulo maths, a difference between a base value and a value smaller than the base value could be expressed as a positive difference. In some examples, a respective difference may be determined between every value in that group of values and the base value - e.g. including a difference of "0" between a value that is determined to be the base value and the base value. In other examples, a respective difference may be determined between each value in that group of values other than the value that is determined to be the base value and the base value. In these other examples, the position of the base value within the group of values may be encoded - e.g. so that the decompression logic can place the base value in the correct position when decoding the group of values. In yet other examples, if the position of the base value is known (e.g. if the group of values are sorted into ascending order such that it is known that the minimum value will be in the "0th" position within that group of values and the minimum value is selected to be the base value, or if the base value is determined to be the value in a predetermined position within the group of values regardless of its magnitude) it may not be necessary to encode a difference of "0" between the value that is determined to be the base value and the base value, or encode the position of the base value within the group of values.

The base value can be encoded using a number of bits sufficient to represent the base value. In an example, the base value can be encoded using the minimum number of bits required to represent the base value. In other examples, the base value can be encoded using a fixed number of bits (e.g. that may exceed the minimum number of bits required to encode the base value) - e.g. 16 bits. The bits used to encode the base value can be referred to as "base value bits".

Each of the one or more differences can be encoded using a number of bits sufficient to represent the difference of the one or more differences that has the greatest magnitude. That is, each of the one or more differences can be encoded by identifying a sufficient (e.g. the minimum) number of bits required to encode the difference of the one or more differences that has the greatest magnitude, and encoding each of the one or more differences using that number of bits. In other words, the same number of bits can be used to encode each of the one or more differences. It is to be understood that, in examples in which the one or more differences include at least one negative difference, each of the one or more differences may be encoded using signed binary (e.g. two's complement) - and the use of signed binary would be taken into account when determining the minimum number of bits required to encode the difference of the one or more differences that has the greatest magnitude. It is also to be understood that most, although not all, of the advantages of the principles described herein would still be realised if a sufficient number of bits were identified that exceeded the minimum number of bits required by a small number of bits (e.g. by 1 to 3 bits). The bits used to encode each of the one or more differences can be referred to as "difference bits".

Data indicating the number of bits used to encode each of the one or more differences can itself be encoded by appending one or more additional "header bits" to the data encoding the values of that group of values.

The additional header bits can be used during decompression of the compressed group of values - e.g. so that the decompression logic can determine which of the "difference bits" relate to each difference. The "base value" bits can be used during decompression of the compressed group of values - e.g. so that the decompression logic can sum the base value with each of the differences to calculate the values of the group of values.

It is to be understood that, in some examples, according to the second compression scheme, a sufficient (e.g. the minimum) number of bits required to encode a difference of 0 may be 0 bits of data (e.g. "no data"), such that if the one or more differences determined for a group of values are all 0, each of the one or more differences could be encoded with 0 bits of data. In other words, in this special case, the compressed group of values may not comprise any "difference bits". Data indicating that 0 bits of data have been used to encode each of the one or more differences can be encoded using one or more "header bits". For example, one header bit (e.g. a "0" bit) may be used to indicate that 0 bits of data have been used to encode each of the one or more differences.

As a worked example, a group of values (as formed in step S206) may comprise the following 8 values: [127, 120, 125, 114, 119, 122, 121, 120]. In raw (e.g. non-compressed) form, each value may be represented using 16 bits, such that a total of 128 bits are required to represent that group of values.

The minimum value (e.g. the value having the smallest absolute value) in that group of values may be determined to be the base value. In this worked example, the base value can therefore be determined to be 114. The base value (e.g. 114) can be encoded using the minimum number of bits required to represent the base value - e.g. 7 base value bits (as 1 1 1 0 0 1 0 in binary). Alternatively, a fixed number of bits exceeding that minimum number of bits could be used to encode the base value - e.g. 16 base value bits.

In a first example, a respective difference may be determined between every value in that group of values and the base value. In the first example, the determined differences would be: 13 (i.e. 127-114), 6 (i.e. 120-114), 11 (i.e. 125-114), 0 (i.e. 114-114), 5 (i.e. (119-114), 8 (i.e. 122-114), 7 (i.e. 121-114) and 6 (i.e. 120-114). In a second example, a respective difference may be determined between each value in that group of values other than the value that is determined to be the base value and the base value. In the second example, the determined differences would be: 13, 6, 11, 5, 8, 7 and 6. In both examples, the difference of the determined differences that has the greatest magnitude is 13, which can be encoded using 4 bits (e.g. as 1 1 0 1 in binary). In other words, it can be identified that this number of bits (e.g. 4 bits) is sufficient to (e.g. the minimum number of bits required to) encode the largest determined difference (i.e. 13) without loss (e.g. "losslessly"). This means that this number of bits (e.g. 4 bits) will also be sufficient to encode each of the other determined differences (i.e. 6, 11, optionally 0, 5, 8, 7 and 6) without loss (e.g. "losslessly"). Therefore, the determined differences can be compressed by encoding each of the differences using 4 bits, such that a total of 32 bits (in the first example) or 28 bits (in the second example) are required to encode the differences. Data indicating that 4 bits have been used to encode each of the determined differences can itself be encoded by appending additional header bits to the data encoding the differences. In an example, the number of additional header bits could be the minimum number of bits required to indicate the number of bits (e.g. 4) used per value - e.g. 3 header bits (e.g. as 1 0 0 in binary). In other examples, a fixed number of additional header bits exceeding that minimum number of bits could be used to indicate the number of bits (e.g. 4) used per determined difference - e.g. 5 header bits.

In the second example, the position of the base value within the group of values may also be encoded. In the worked example, the base value is the 3rd value (using zero indexing) in the group of values. The position of the base value could be encoded using the minimum number of bits required to indicate the position ("3") of the base value - e.g. 2 base position bits (e.g. as 1 1 in binary). Alternatively, a fixed number of bits exceeding that minimum number of bits could be used to indicate the position ("3") of the base value - e.g. 3 base position bits.

In the worked example, for all examples of the second compression scheme described herein, a smaller amount of data (e.g. fewer bits of data) are required to represent the compressed group of values relative to the group of values in its raw (e.g. non-compressed) form.

The second compression scheme described herein is particularly efficient for compressing groups of values (as formed in step S206) that include a plurality of values having a large magnitude, and no "outlying" values e.g. one or more values that are significantly larger or smaller than the majority of the values in that group of values. This is because, although each of the values may have a large magnitude, the differences between a base value determined in dependence on those values and the other values of the group of values may have a small magnitude.

*Third compression scheme*

One or more groups of values of the plurality of groups of values (as formed in step S206) can be compressed according to a third compression scheme in which, for each of the one or more groups of values, a base value is determined in dependence on the values of that group of values. Determining the base value could comprise determining the minimum value, the maximum value, the median value, the mode value, or the mean of that group of values, or a value within a predetermined position within the group of values, to be the base value - although it is to be understood that any other suitable base value could alternatively be determined. The minimum value may be the value having the smallest absolute value. The maximum value may be the value having the largest absolute value. A base difference can be determined between the base value and a first value of that group of values. In examples in which the base value is not positioned in the "0th" position (using zero indexing) within the group of values, the base difference can be determined between the base value and the value in the "0th" position within that group of values. In examples in which the base value is positioned in the "0th" position (using zero indexing) within the group of values, the base difference can be determined between the base value and the value in the "1st" position within that group of values. The base difference could be positive or negative. Note that, in some examples, by exploiting to the "wrap around" property of modulo maths, a difference between a base value and a value smaller than the base value could be expressed as a positive difference. For each of one or more values of that group of values other than the first value, a respective adjacency difference between that value and an adjacent value of that group of values can also be determined. By way of examples, adjacency differences can be determined between

values in the "2nd" and "1st" positions, "3rd" and "2nd" positions, "4th" and "3rd" positions etc, within the group of values. Each determined adjacency difference could be positive or negative. Note that, in some examples, by exploiting to the "wrap around" property of modulo maths, a difference between a value and adjacent value smaller than that value could be expressed as a positive difference. In examples in which the base difference is determined between the base value and the value in the "0th" position within that group of values, the number of adjacency differences determined can be one fewer than the number of values in the group. In examples in which the base difference is determined between the base value and the value in the "1st" position within that group of values, the number of adjacency differences determined can be two fewer than the number of values in the group.

The base value can be encoded using a number of bits sufficient to represent the base value. In an example, the base value can be encoded using the minimum number of bits required to represent the base value. In other examples, the base value can be encoded using a fixed number of bits (e.g. that may exceed the minimum number of bits required to encode the base value) - e.g. 16 bits. The bits used to encode the base value can be referred to as "base value bits".

Each of the base difference and the one or more adjacency differences can be encoded using a number of bits sufficient to represent the difference of the base difference and the one or more adjacency differences that has the greatest magnitude. That is, each of the base difference and the one or more adjacency differences can be encoded by identifying a sufficient (e.g. the minimum) number of bits required to encode the difference of the base difference and the one or more adjacency differences that has the greatest magnitude, and encoding each of the base difference and the one or more adjacency differences using that number of bits. In other words, the same number of bits can be used to encode each of the base difference and the one or more adjacency differences. It is to be understood that, in examples in which the base difference and the one or more adjacency differences include at least one negative difference, each of the base difference and the one or more adjacency differences may be encoded using signed binary (e.g. two's complement) - and the use of signed binary would be taken into account when determining the minimum number of bits required to encode the difference of the base difference and the one or more adjacency differences that has the greatest magnitude. It is also to be understood that most, although not all, of the advantages of the principles described herein would still be realised if a sufficient number of bits were identified that exceeded the minimum number of bits required by a small number of bits (e.g. by 1 to 3 bits). The bits used to encode each of the base difference and the one or more adjacency differences can be referred to as "difference bits".

Data indicating the number of bits used to encode each of the base difference and the one or more adjacency differences can itself be encoded by appending one or more additional "header bits" to the data encoding the values of that group of values.

The additional header bits can be used during decompression of the compressed group of values - e.g. so that the decompression logic can determine which of the "difference bits" relate to each of the base difference and the one or more adjacency differences. The "base value" bits can be used during decompression of the compressed group of values - e.g. so that the decompression logic can sum the base value with the base difference to calculate the first value, and subsequently perform a series of sums using the one or more adjacency differences to calculate the other values of the group of values.

It is to be understood that, in some examples, according to the third compression scheme, a sufficient (e.g. the minimum) number of bits required to encode a difference of 0 may be 0 bits of data (e.g. "no data"), such that if the base difference and the one or more adjacency differences determined for a group of values are all 0, each of the base difference and the one or more adjacency differences could be encoded with 0 bits of data. In other words, in this special case, the compressed group of values may not comprise any "difference bits". Data indicating that 0 bits of data have been used to encode each of the base difference and the one or more adjacency differences can be encoded using one or more "header bits". For example, one header bit (e.g. a "0" bit) may be used to indicate that 0 bits of data have been used to encode each of the base difference and the one or more adjacency differences.

As a worked example, a group of values (as formed in step S206) may comprise the following 8 values: [50, 51, 48, 54, 59, 60, 61, 63]. In raw (e.g. non-compressed) form, each value may be represented using 16 bits, such that a total of 128 bits are required to represent that group of values.

The minimum value (e.g. the value having the smallest absolute value) in that group of values may be determined to be the base value. In this worked example, the base value can therefore be determined to be 48. The base value (e.g. 48) can be encoded using the minimum number of bits required to represent the base value - e.g. 6 base value bits (as 1 1 0 0 0 0 in binary). Alternatively, a fixed number of bits exceeding that minimum number of bits could be used to encode the base value - e.g. 16 base value bits.

A base difference can be determined between the base value and a first value of the group of values. In this worked example, the base value (e.g. 48) is not positioned in the "0th" position (using zero indexing) within the group of values, and so the base difference can be determined between the base value (e.g. 48) and the value (e.g. 50) in the "0th" position within that group of values. As such, in this worked example, the base difference can be -2 (i.e. 48-50).

For each of the values of the group of values other than the first value, a respective adjacency difference between that value and an adjacent value of that group of values can also be determined. In this worked example, the adjacency differences would be: 1 (i.e. 51-50), -3 (i.e. 48-51), 6 (i.e. 54-48), 5 (i.e. 59-54), 1 (i.e. 60-59), 1 (i.e. 61-60) and 2 (i.e. 63-61).

The difference of the base difference and the one or more adjacency differences that has the greatest magnitude is 6, which can be encoded using 4 bits (e.g. as 0 1 1 0 in signed binary). In other words, it can be identified that this number of bits (e.g. 4 bits) is sufficient to (e.g. the minimum number of bits required to, when using signed binary) encode the largest determined difference (i.e. 6) without loss (e.g. "losslessly"). This means that this number of bits (e.g. 4 bits) will also be sufficient to encode each of the other determined differences (i.e. -2, 1, -3, 5, 1, 1, and 2) without loss (e.g. "losslessly"). Therefore, the determined differences can be compressed by encoding each of the differences using 4 bits, such that a total of 32 bits are required to encode the differences. Data indicating that 4 bits have been used to encode each of the determined differences can itself be encoded by appending additional header bits to the data encoding the differences. In an example, the number of additional header bits could be the minimum number of bits required to indicate the number of bits (e.g. 4) used per value - e.g. 3 header bits (e.g. as 1 0 0 in binary). In other examples, a fixed number of additional header bits exceeding that minimum number of bits could be used to indicate the number of bits (e.g. 4) used per determined difference - e.g. 5 header bits.

In the worked example, for all examples of the third compression scheme described herein, a smaller amount of data (e.g. fewer bits of data) are required to represent the compressed group of values relative to the group of values in its raw (e.g. non-compressed) form.

The third compression scheme described herein is particularly efficient for compressing groups of values (as formed in step S206) in which the values of that group of values are in sorted (or approximately sorted) order (e.g. in ascending or descending order) within the group of values, and the group of values does not include any "outlying" values (e.g. one or more values that are significantly larger or smaller than the majority of the values in that group of values). This is because the differences between adjacent values in a sorted group of values can have a small magnitude.

As will be understood from the descriptions above, both the second compression scheme and the third compression scheme can use fewer bits to represent a groups of values if the values of that group of values are in sorted order (e.g. in ascending or descending order) within that group of values. For example, sorting a group of values into ascending order causes the value in the "0th" position within that group of values to be the minimum value (e.g. the value having the smallest absolute value). As above, in the second compression scheme, if it is known that the minimum value will be in the "0th" position and the minimum value is selected to be the base value, it may not be necessary to encode a difference of "0" between the value that is determined to be the base value and the base value, or encode the position of the base value within the group of values. Also as above, in the third compression scheme, if it is known that the minimum value will be in the "0th" position and the minimum value is selected to be the base value, the base difference can be determined between the base value and the value in the "1st" position within that group of values, meaning that one fewer adjacency differences can be determined and encoded for that group of values. For this reason, step S208 may further comprise, for each of one or more groups of values to be compressed, sorting the values of that group into ascending or descending order prior to compressing that group of values according to the second compression scheme or the third compression scheme.

Returning to Figure 2, step S208 may further comprise storing the compressed set of values to memory (e.g. memory 104). That is, step S208 may further comprise storing each of the compressed groups of values to memory (e.g. memory 104). In some examples, in addition to the compressed set of values, data indicating how the rows and/or columns of the matrix were reordered in step S206 may also be stored in memory (e.g. memory 104). By way of example, a one-dimensional array of integers could be stored in memory to indicate how the rows or columns of the matrix were reordered in step S206. That is, a one-dimensional array of integers could be stored in memory to indicate how the rows of the matrix were reordered in step S206 and/or a one-dimensional array of integers could be stored in memory to indicate how the columns of the matrix were reordered in step S206. This data can be used during decompression of the compressed set of values - e.g. so that the decompression logic can "undo" (e.g. reverse) the reordering of the rows and/or columns of the matrix that was performed in step S206. For example, data indicating how the rows of the matrix were reordered in step S206 may comprise a one-dimensional array that specifies the mapping of rows, such as the one-dimensional array [7, 12, 9, ...], where the i-th integer in the array indicates that, to undo the row reordering during decompression, the i-th row of the matrix should be moved to the row corresponding to that integer (e.g., using the one-dimensional array [7, 12, 9, ...], row 1 moves to row 7, row 2 to row 12, row 3 to row 9, and so on). Such a one-dimensional array can itself be compressed using any of the compression schemes described herein with reference to step S208, before being stored in memory. That is, the one-dimensional array may be compressed as a single group of integers using any of the compression schemes described herein with reference to step S208; or the one-dimensional array may be divided into a plurality of groups of integers, each of said groups of integers being independently (e.g. separately) compressed using any of the compression schemes described herein with reference to step S208. In other examples, such as in neural network applications that will be described in further detail herein, it may not be necessary to undo (e.g. reverse) the reordering of the rows and/or columns of the matrix that was performed in step S206 during decompression, meaning that data indicating how the rows and/or columns of the matrix were reordered in step S206 need not be stored in memory.

The compressed set of values can be subsequently used in one or more computer-implemented applications - e.g. image processing or display applications, audio processing or play-out applications, neural network applications, or any other suitable computer-implemented applications. For example, the compressed set of values may be decompressed and subsequently processed by other logic (not shown) comprised by processing system 100, or by an external system.

*Neural network applications*

In some examples, the principles described herein can be used to compress weights of a neural network (e.g. form compressed set(s) of values that encode set(s) of weights of a neural network). In these examples, a compressed set of values (as output from step S208) can subsequently be used to configure and/or implement a neural network. That is, the methods described herein may further comprise configuring a neural network in dependence on the compressed set of values. The methods described herein may further comprise implementing a neural network using the compressed set of values. Implementing a neural network using the compressed set of values may comprise reading the compressed set of values from memory, decompressing that set of values so as to generate a set of weights of the neural network, and then operating on neural network activation data using that set of weights. The neural network may be implemented in hardware, software, or any combination thereof. As is understood by the skilled person, the neural network may be implemented at hardware logic comprising a neural network accelerator (NNA) and/or at a graphics processing unit (GPU), which may optionally comprise one or more accelerators for accelerating one or more neural network operations. The implemented neural network can be configured to perform signal processing applications, including, but not limited to, image processing. Examples of image processing applications that the implemented neural network can be configured to perform include: image super-resolution processing, semantic image segmentation processing and object detection. For example, performing image super-resolution processing involves a neural network processing a lower-resolution image input to the neural network in order to output a higher-resolution image. In other words, the methods described herein may further comprise implementing a neural network using the compressed set of values, and using that neural network to perform image processing (e.g. to process image data). That said, it will be appreciated that the principles described herein are not limited to use in compressing the weights of a neural network configured to performing image processing. For example, the principles described herein could be used in compressing the weights of a neural network configured to perform speech recognition/speech-to-text applications, or any other suitable types of applications. The skilled person would understand how to configure a neural network to perform any of the applications mentioned in this paragraph, and so for conciseness these techniques will not be discussed in any further detail.

*Background*

A neural network is a form of artificial network comprising a plurality of interconnected layers (e.g. "layers"). Figure 7 illustrates an example neural network 700 that comprises a plurality of adjacent layers 702-1, 702-2, 702-3. Each layer 702-1, 702-2, 702-3 receives a set of input activation values. The set of input activation values received by a layer may be referred to as input activation data of that layer. Each layer 702-1, 702-2, 702-3 processes its respective received input activation data by performing an operation in accordance with that layer to produce output data. The output data is either provided to a subsequent layer as the input activation data of that layer (e.g. the output data is "output activation data") or is output as the final output data of the neural network. For example, in the neural network 700, the first layer 702-1 receives the input activation data 704 originally input to the neural network 700 and processes that input activation data by performing a first operation in accordance with the first layer 702-1 to produce output activation data. The output activation data of the first layer 702-1 becomes the input activation data to the second, subsequent, layer 702-2 which processes that input activation data by performing a second operation in accordance with the second layer 702-2 to produce output activation data. The output activation data of the second layer 702-2 becomes the input activation data to the third, subsequent, layer 702-3 which processes that input activation data by performing a third operation in accordance with the third layer 702-3 to produce output data. The output data of the third layer 702-3 is output as the output data 706 of the neural network.

Each layer of a neural network may be one of a plurality of different types. The type of operation that is performed on the input activation data of a layer depends on the type of layer. Fully connected layers (sometimes referred to as dense layers or linear layers) and convolutional layers are example types of neural network layer.

*Compressing weights of a fully connected layer*

In a fully connected layer, a fully connected operation is performed by performing matrix multiplication between a weight matrix comprising weights of that fully connected layer and an input matrix comprising input activation values received by that fully connected layer. The purpose of a fully connected layer is to cause a dimensional change between the activation data input to that layer and the data output from that layer. A weight matrix comprising the weights of that fully connected layer may have dimensions $C_{out} \times C_{in}$. That is, the number of rows of the matrix may be representative of the number of output channels ("$C_{out}$") of that fully connected layer and the number of columns of the matrix may be representative of the number of input channels ("$C_{in}$") of that fully connected layer. In other words, each row of the matrix may be representative of an output channel of that fully connected layer and each column of the matrix may be representative of an input channel of that fully connected layer. In a fully connected layer, a matrix multiplication $WX = Y$ can be performed where: $W$ is the weight matrix comprising the weights and having dimensions $C_{out} \times C_{in}$; $X$ is the input matrix comprising input activation values and having dimensions $M \times N$, where $C_{in} = M$; and $Y$ is an output matrix comprising output values and having dimensions $C_{out} \times N$. Alternatively, a weight matrix comprising the weights of that fully connected layer may have dimensions $C_{in} \times C_{out}$. That is, the number of rows of the matrix may be representative of the number of input channels

("$C_{in}$") of that fully connected layer and the number of columns of the matrix may be representative of the number of output channels ("$C_{out}$") of that fully connected layer. In other words, each row of the matrix may be representative of an input channel of that fully connected layer and each column of the matrix may be representative of an output channel of that fully connected layer. In this alternative, in a fully connected layer, a matrix multiplication $XW = Y$ can be performed where: $X$ is the input matrix comprising input activation values and having dimensions $M \times N$; $W$ is the weight matrix comprising the weights and having dimensions $C_{in} \times C_{out}$, where $C_{in} = N$; and $Y$ is an output matrix comprising output values and having dimensions $M \times C_{out}$. A matrix multiplication involves performing a number of element-wise multiplications between coefficients of the coefficient matrix and activation values of the input matrix. The results of said element-wise multiplications can be summed (e.g. accumulated) so as to generate the output data values of the output matrix.

The method of compressing a set of values described herein with reference to Figure 2 can be used to compress a set of weights of a fully-connected layer of a neural network. As above, the weights of a fully connected layer are typically arranged in a matrix (e.g. the "weight matrix" described above). As such, a set of weights of a fully connected layer can be compressed by inputting that weight matrix into the method of compressing a set of values described herein with reference to Figure 2. The set of values comprised by the matrix determined in step S202 may comprise the weights of that fully-connected layer (e.g. in examples in which a pre-processing operation as described herein is not performed in step S202), or may represent the weights of that fully-connected layer (e.g. in examples in which a pre-processing operation as described herein is performed on each of the received weights in step S202). Each row of the matrix determined in step S202 may be representative of a respective output channel of that fully connected layer and each column of the matrix determined in step S202 may be representative of a respective input channel of that fully connected layer; or, alternatively, each row of the matrix determined in step S202 may be representative of a respective input channel of that fully connected layer and each column of the matrix determined in step S202 may be representative of a respective output channel of that fully connected layer.

The set of values comprised by the matrix determined in step S202 may comprise or represent all of the weights of a fully-connected layer of a neural network. That said, it is to be understood that the set of values comprised by the matrix determined in step S202 need not comprise or represent all of the weights of a fully-connected layer of a neural network. For example, the set of values comprised by the matrix determined in step S202 may comprise or represent a subset of the weights of a fully-connected layer, e.g. the subset of the weights of a fully-connected layer that are represented by a sub-matrix formed as described in UK patent application GB2623468 A. It is to be understood that "a subset of the weights of a fully-connected layer" could itself be referred to as "a set of weights of the fully-connected layer".

*Compressing weights of a convolutional layer*

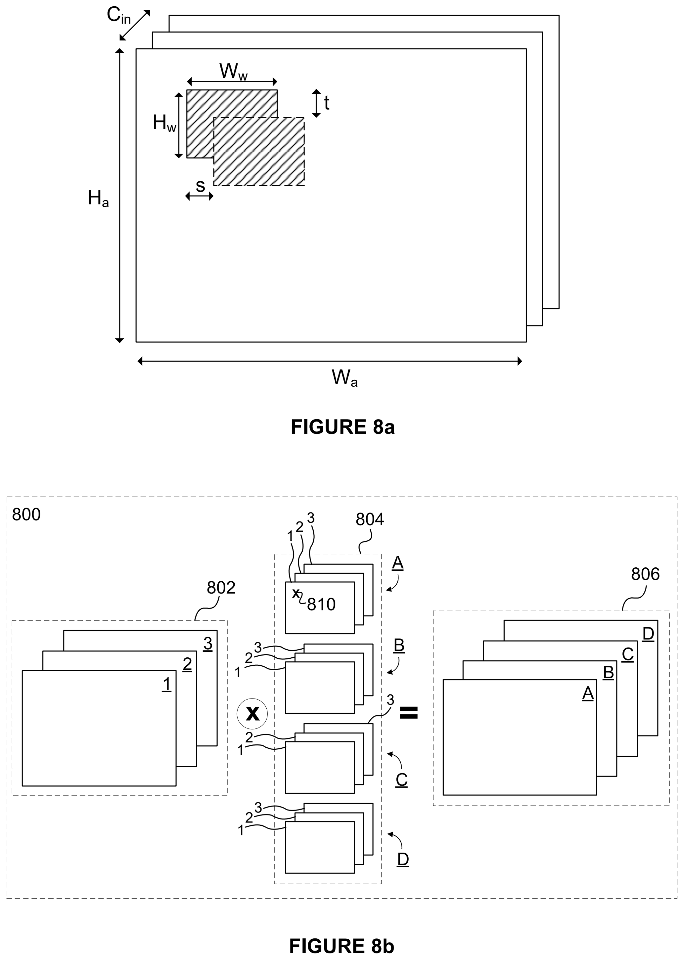

In a convolutional layer, a convolution operation is performed using input activation values received by that convolutional layer and weights of that convolutional layer. Figure 8a shows the data structure used in an example convolutional layer. In Figure 8a, the input activation data of a convolutional layer may have the dimensions $C_{in} \times H_a \times W_a$. In other words, the input activation data may be arranged as $C_{in}$ input channels, where each input channel has a spatial dimension $H_a \times W_a$ - where $H_a$ and $W_a$ are, respectively, height and width dimensions. In Figure 8a, the input activation data is shown comprising three input channels (i.e. $C_{in} = 3$). The weights of a convolutional layer can be arranged in one or more input channels and one or more output channels. In Figure 8a, the weights have dimensions $C_{out} \times C_{in} \times H_w \times W_w$. The number of input channels in the weights of a convolutional layer corresponds to (e.g. is equal to) the number of input channels in the input activation data with which those weights is to be convolved (e.g. in the example shown in Figure 8a, $C_{in} = 3$). Each input channel of each output channel of the weights input to a convolutional layer has a spatial dimension $H_w \times W_w$ - where $H_w$ and $W_w$ are, respectively, height and width dimensions. Each input channel of each output channel comprises a respective subset of the weights of the convolutional layer. Each weight is included in (e.g. comprised by, or part of) one input channel and one output channel. The $C_{out}$ dimension (e.g. number of output channels) is not shown in Figure 8a - but denotes the number of channels that will be generated in the output data by performing a convolution operation using the weights.

Figure 8b schematically illustrates an example convolutional layer 800. In Figure 8b, convolutional layer 800 is arranged to perform a convolution operation using input activation data 802 and weights 804. In Figure 8b, activation data 802 input to layer 800 is arranged in three input channels 1, 2, 3. The number of input channels in the weights 804 corresponds to (e.g. is equal to) the number of input channels in the activation data 802 with which those weights 804 is to be convolved. Hence, the weights 804 is arranged in three input channels 1, 2, 3. The weights 804 is also arranged in four output channels A, B, C, D. The number of output channels in the weights 804 corresponds to (e.g. is equal to) the number of channels in output data 806. Each weight is included in (e.g. comprised by, or part of) one input channel and one output channel. For example, weight 210 is included in input channel 1 and output channel A.

In convolutional layer 800, the input activation data 802 is convolved with the weights 804 so as to generate output data 806 having four data channels A, B, C, D. More specifically, the first input channel of the input activation data 802 is convolved with the first input channel of each output channel in the weights 804. For example, returning to Figure 8a, the first input channel of the input activation data 802, having spatial dimensions $H_a \times W_a$, may be convolved with the first input channel of each output channel in the weights 804, having spatial dimensions $H_w \times W_w$, across a number of steps in direction $s$ and $t$. Returning to Figure 8b, in an analogous way, the second input channel of the input activation data 802 is convolved with the second input channel of each output channel in the weights 804, and the third input channel of the input activation data 802 is convolved with the third input channel of each output channel in the weights 804. Convolving each input channel of the input activation data with each input channel of each output channel involves performing a number of element-wise multiplications between the activation values of each input channel of the input activation data and the coefficients of each input channel of each output channel. The results of said element-wise multiplications can be summed (e.g. accumulated) so as to generate the output data values for each channel of output data 806.

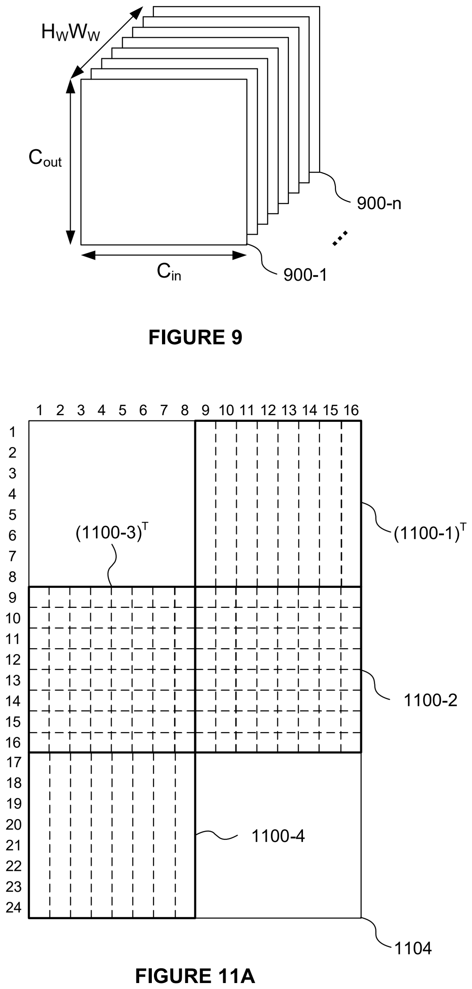

The method of compressing a set of values described herein with reference to Figure 2 can be used to compress a set of weights of a convolutional layer of a neural network. As above, the weights of a convolutional layer are four-dimensional, having dimensions $C_{out} \times C_{in} \times H_w \times W_w$. In step S202, a tensor having three-dimensions can be formed to represent those four-dimensional weights. That three-dimensional tensor can have the dimensions $C_{out} \times C_{in} \times (H_w W_w)$. Alternatively, that three-dimensional tensor can have the dimensions $C_{in} \times C_{out} \times (H_w W_w)$. Put another way, that three-dimensional tensor can comprise a plurality of (i.e. $(H_w W_w)$) two-dimensional planes, each two-dimensional plane having dimensions $C_{out} \times C_{in}$ or $C_{in} \times C_{out}$. As an illustrative example, Figure 9 shows a plurality of (i.e. $(H_w W_w)$) two-dimensional planes (900-1 to 900-n) having dimensions $C_{out} \times C_{in}$ representing the four-dimensional weights of a convolutional layer of a neural network. Each two-dimensional plane is a formed matrix comprising a subset of the weights of that convolutional layer. It is to be understood that "a subset of the weights of a convolutional layer" could itself be referred to as "a set of weights of the convolutional layer". Step 202 may comprise determining a plurality of (i.e. $(H_w W_w)$) matrices, each determined matrix corresponding to one of said two-dimensional planes. The set of values comprised by each matrix determined in this manner may comprise a respective subset of the weights of that convolutional layer (e.g. in examples in which a pre-processing operation as described herein is not performed in step S202), or may represent a respective subset of the weights of that convolutional layer (e.g. in examples in which a pre-processing operation as described herein is performed on each of the received weights in step S202). Put another way, step S202 may comprise determining a plurality of matrices, each comprising a respective set of values that comprise or represent a respective subset of the weights of a convolutional layer. Each row of each of the plurality of matrices determined in step S202 may be representative of an output channel of that convolutional layer and each column of each of the plurality of matrices determined in step S202 may be representative of an input channel of that convolutional layer; or, alternatively, each row of each of the plurality of matrices determined in step S202 may be representative of an input channel of that convolutional layer and each column of each of the plurality of matrices determined in step S202 may be representative of an output channel of that convolutional layer. In a first example in which each matrix determined in step S202 has dimensions $C_{out} \times C_{in}$, the number of rows of the matrix is representative of the number of output channels ("$C_{out}$") of that convolutional layer and the number of columns of the matrix is representative of the number of input channels ("$C_{in}$") of that convolutional layer. In the first example, each row of the matrix is representative of an output channel of that convolutional layer and each column of the matrix is representative of an input channel of that convolutional layer. In a second example in which each matrix has dimensions $C_{in} \times C_{out}$, the number of rows of the matrix is representative of the number of input channels ("$C_{in}$") of that convolutional layer and the number of columns of the matrix is representative of the number of output channels ("$C_{out}$") of that convolutional layer. In the second example, each row of the matrix is representative of an input channel of that convolutional layer and each column of the matrix is representative of an output channel of that convolutional layer.

The respective set of values, which comprise or represent a respective subset of the weights of the convolutional layer, comprised by each of the determined matrices can be compressed according to the method described herein with reference to Figure 2. That said, when performing the method described herein with reference to Figure 2 for the weights of a convolutional layer, in step S206, the same row and/or column reordering is preferably performed for each of the determined matrices such that the same reordering is applied to the output and/or input channels of the convolutional layer that are represented by the rows and/or columns of each of the matrices. That is, considering a first matrix and a second matrix of the determined matrices, in step S206, the reordering of the rows and/or columns of the first matrix may correspond to (e.g. match) the reordering of the rows and/or columns of the second matrix. For example, if the columns of the first matrix are reordered as in the example shown in Figure 5A (e.g. such that columns 1 to 16 of the first matrix are in the order: 2, 7, 10, 16, 4, 9, 13, 3, 1, 11, 6, 8, 15, 14, 12, 5), then the columns of the second matrix should also be reordered as in the example shown in Figure 5A (e.g. such that columns 1 to 16 of the second matrix are in the order: 2, 7, 10, 16, 4, 9, 13, 3, 1, 11, 6, 8, 15, 14, 12, 5).

To achieve this, in step S204, the assessed similarities between corresponding pairs of rows and/or corresponding pairs of columns of each of the determined matrices can be combined. That is, for each matrix, the similarity between pairs of rows and/or pairs of columns of that matrix can be assessed as described herein with respect to step S204 (e.g. by calculating an L1 distance between each pair of rows or columns). Then, the assessed similarities for corresponding pairs of rows and/or columns in each of the matrices (e.g. those pairs of rows and/or columns of each of the matrices that represent the same pairs of output and/or input channels of the convolutional layer) can be combined (e.g. summed, multiplied or combined in any other suitable manner). For example, the assessed similarity (e.g. calculated L1 distance) between a pair or rows or columns p and q of a first matrix comprising a first set of values that comprise or represent a first subset of the weights of a convolutional layer can be combined (e.g. summed, multiplied or combined in any other suitable manner) with the assessed similarity (e.g. calculated L1 distance) between the corresponding pair of rows or columns p and q of a second matrix comprising a second set of values that comprise or represent a second subset of the weights of that convolutional layer. Next, the rows and/or columns of each of the matrices can be reordered in step S206 in dependence on the combined assessed similarities such that the same row and/or column reordering is performed for each of the determined matrices. For example, in order to perform a one-dimensional reordering of each of the determined matrices, a single fully-connected graph can be formed in which each vertex represents multiple corresponding rows or columns (e.g. the "$n^{th}$" row or column of each of the matrices) and each edge is associated with a cost that depends on the combined assessed similarity determined for the corresponding pairs of rows or columns of each of the matrices that are represented by the vertices connected by that edge. That fully-connected graph can be partitioned into a plurality of parts as described herein. The rows or columns of each of the determined matrices can be reordered in the same manner in dependence on that partitioned fully-connected graph. A two-dimensional reordering of each of the determined matrices can be performed by independently performing two such one-dimensional reordering processes, as described herein.

Step 208 can then be performed as described herein, independently (e.g. separately), using the groups of values formed in each of the matrices so as to compress the weights of the convolutional layer.

It is to be understood that, during decompression, the decompressed weights can be used to re-form the four-dimensional weights of the convolutional layer, e.g. having dimensions $C_{out} \times C_{in} \times H_w \times W_w$.

The sets of values comprised by the plurality of matrices determined in step S202 may comprise or represent all of the weights of a convolutional layer of a neural network. That said, it is also to be understood that the sets of values comprised by the plurality of matrices determined in step S202 need not comprise or represent all of the weights of a convolutional layer of a neural network. For example, the sets of values comprised by the plurality of matrices determined in step S202 may comprise or represent a subset of the weights of a convolutional layer, e.g. the subset of the weights of a convolutional layer that are represented by a sub-matrix formed as described in UK patent application GB2623468 A. As such, the set of values comprised by each of the matrices determined in step S202 may comprise or represent a subset of that subset of the weights of a convolutional layer of a neural network. It is to be understood that "a subset of a subset of the weights of a convolutional layer" could itself be referred to as "a set of weights of the convolutional layer".

*Compressing sets of weights of a series of neural network layers*

As described herein, in neural network applications, during decompression, it may not be necessary to "undo" (e.g. reverse) the reordering of the rows and/or columns of the matrix that was performed in step S206, meaning that data indicating how the rows and/or columns of the matrix were reordered in step S206 need not be stored in memory.

Instead, sets of weights of a series of adjacent layers of the neural network can be compressed in dependence on one another. The series of adjacent layers may comprise, at least, a first layer of the neural network and a second layer of the neural network. The first layer may be arranged to perform a first operation. The second layer may be arranged to perform a second operation. The set of activation values output by the first layer (e.g. as a result of performing the first operation) are the set of activation values input to the second layer. As such, the first layer may be referred to as a preceding layer and the second layer may be referred to as a subsequent layer. The one or more output channels of the first layer correspond to the one or more input channels of the second layer. In other words, for 1 to $N$, the $N^{th}$ output channel of the weights of the first layer may be responsible for forming the channel of output activation data that will be operated on by the $N^{th}$ input channel of the weights of the second layer. That is, an output channel of a preceding layer can be said to correspond to an input channel of a subsequent layer when it is responsible for forming the channel of activation data that will be operated on by that input channel. An input channel of a subsequent layer can be said to correspond to an output channel of a preceding layer when it is responsible for operating the channel of activation data formed by that output channel. The first layer and the second layer may both be arranged to perform the same type of operation. In a first example, the first layer and the second layer may both be fully connected layers. In a second example, the first layer and the second layer may both be convolutional layers. Alternatively, the first layer and the second layer may be arranged to perform different types of operation. For example, the first layer may be a convolutional layer and the second layer may be a fully connected layer.

The weights of each layer in that series of adjacent layers can be compressed by performing the method described herein with reference to Figure 2. In addition, the inventors have realised that, if the reordering of the input channels of each "subsequent" layer performed during the compression (caused by reordering the rows or columns of the matrices representing the input channels of sets of weights of each "subsequent" layer) corresponds to (e.g. matches) the reordering of the corresponding output channels of each "preceding" layer performed during the compression (caused by reordering the rows or columns of the matrices representing the corresponding output channels of sets of weights of each "preceding" layer), then when the sets of weights are decompressed to implement the neural network, the activation values output by the operation performed by the reordered "preceding" layer can be input directly into the operation performed by the reordered "subsequent" layer - e.g. such that the neural network can be implemented without needing to "undo" the reordering of the channels of the sets of weights of the "preceding" and "subsequent" layers, and without needing to rearrange the activation values output by the "preceding" layer before they are input to the "subsequent" layer. As would be understood by the skilled person, so long as the input channels of the weights of the first layer of the neural network are not reordered, and the output channels of the weights of the final layer of the neural network are not reordered, the input and output of the neural network, when implemented, will not be changed by reordering the channels of the weights of the intermediate layers in this way during compression.

*To compress one-dimensional groups of values comprising or representing weights*

If it is desired to compress one-dimensional groups of values of sets of values that comprise or represent sets of weights of a series of adjacent fully connected or convolutional layers in a manner that the neural network can subsequently be implemented without needing to "undo" the reordering of the rows and/or columns of the matrix that represent the channels of those sets of weights during decompression, this can be achieved by performing an additional reordering step within the method described herein with reference to Figure 2. For each matrix of a plurality of matrices that comprise sets of values that comprise or represent sets of weights of a series of adjacent layers, the rows or columns of that matrix can be reordered in dependence on the similarity between pairs of rows or pairs of columns of that matrix (e.g. by performing a one-dimensional reordering as described herein with respect to step S206), and the other of the rows or columns of that matrix can also be reordered to correspond with (e.g. in a manner that matches) the reordering of the rows or columns of the matrix comprising a set of values that comprise or represent a set of weights of an adjacent layer. This additional reordering step can be performed such that said other of the rows or columns of that matrix that represent the input or output channels of a layer are reordered to correspond with (e.g. in a manner that matches) the reordering of the rows or columns of the matrix that represent the corresponding input or output channels of an adjacent layer. This additional reordering step can be performed before performing step S208 as described herein. It is to be understood that this additional reordering step does not change which values of the set of values are comprised by each one-dimensional group of values to be compressed, although it may change the position of that one-dimensional group of values within the matrix. When performing this additional reordering step during the compression of the set of weights of a convolutional layer, the same row or column reordering should be applied to each of the matrices comprising a respective set of values that comprise or represent a respective subset of the weights of that convolutional layer.

In other words, step S206 may comprise, so as to form a plurality of groups of values of a set of values comprised by a matrix, that set of values comprising or representing a set of weights of a layer of a neural network, reordering the rows or columns of the matrix in dependence on the similarity between pairs of rows or pairs of columns of that matrix (as described herein with respect to step S206), and reordering the other of the rows or columns of the matrix to correspond with (e.g. in a manner that matches) the reordering of rows or columns of a further matrix comprising a further set of values that comprises or represents a further set of weights of an adjacent layer of the neural network, said rows or columns of the further matrix being representative of input or output channels of the further set of weights of the adjacent layer that correspond with the input or output channels of the layer represented by said other of the rows or columns of the matrix.

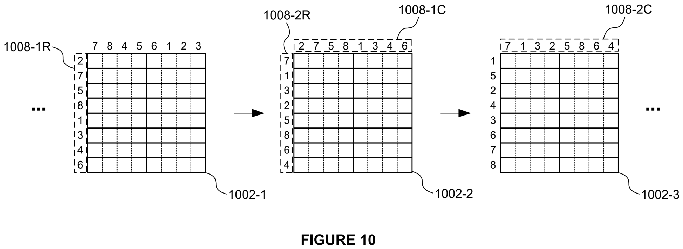

As an illustrative example, Figure 10 shows a plurality of matrices comprising sets of values that comprise or represent sets of weights of a series of adjacent layers of a neural network. Matrix 1002-1 comprises a set of values that comprises or represents a set of weights of a first layer in the series of adjacent layers, matrix 1002-2 comprises a set of values that comprises or represents a set of weights of a second layer in the series of adjacent layers, matrix 1002-3 comprises a set of values that comprises or represents a set of weights of a third layer in the series of layers. The first layer can be referred to as a preceding layer relative to the second layer. The second layer can be referred to as a subsequent layer relative to the first layer, and a preceding layer relative to the third layer. The third layer can be referred to as a subsequent layer relative to the second layer. For ease of illustration, each of the layers are fully connected layers, although it is to be understood that the same principles can be applied to a series of convolutional layers.

In some examples, the rows of each of the matrices may be representative of output channels of each of the layers, and the columns of each of the matrices may be representative of input channels of each of the layers. The represented output channels of the first layer correspond to the represented input channels of the second layer, and the represented output channels of the second layer correspond to the represented input channels of the third layer. As shown in Figure 10, in these examples, the columns of each of the matrices can be reordered in dependence on the similarity between the pairs of columns (as described herein with respect to step S206), and the rows of each of the matrices can be reordered so as to correspond with (e.g. in a manner that matches) the reordering of the columns of the matrix comprising the set of values that comprises or represents a set of weights of the subsequent layer. For example, as shown in Figure 10, the rows 1008-1R of matrix 1002-1 have been reordered so as to correspond with the reordering of the columns 1008-1C of matrix 1002-2; and the rows 1008-2R of matrix 1002-2 have been reordered so as to correspond with the reordering of the columns 1008-2C of matrix 1002-3. Alternatively in these examples (not shown in Figure 10), the rows of each of the matrices can be reordered in dependence on the similarity between the pairs of rows (as described herein with respect to step S206), and the columns of each of the matrices can be reordered so as to correspond with (e.g. in a manner that matches) the reordering of the rows of the matrix comprising the set of values that comprises or represents a set of weights of the preceding layer.

In other examples, the columns of each of the matrices may be representative of output channels of each of the layers, and the rows of each of the matrices may be representative of input channels of each of the layers. The represented output channels of the first layer correspond to the represented input channels of the second layer, and the represented output channels of the second layer correspond to the represented input channels of the third layer. In these examples, the columns of each of the matrices can be reordered in dependence on the similarity between the pairs of columns (as described herein with respect to step S206), and the rows of each of the matrices can be reordered so as to correspond with (e.g. in a manner that matches) the reordering of the columns of the matrix comprising the set of values that comprises or represents a set of weights of the preceding layer. Alternatively in these examples, the rows of each of the matrices can be reordered in dependence on the similarity between the pairs of rows (as described herein with respect to step S206), and the columns of each of the matrices can be reordered so as to correspond with (e.g. in a manner that matches) the reordering of the rows of the matrix comprising the set of values that comprises or represents a set of weights of the subsequent layer.

Step S208 can then be performed as described herein using the one-dimensional groups of values formed in each of the matrices so as to compress the sets of weights of the series of adjacent layers of the neural network. Step S208 can be performed independently (e.g. separately) for each of the matrices. In these examples, the method described herein with reference to Figure 2 may further comprise configuring the neural network in dependence on the compressed set(s) of values, e.g. configuring the neural network to process neural network activation data using weights, the input and output channels of which are reordered in accordance with the matrix reordering performed during the compression method.

*To compress two-dimensional groups of values comprising or representing weights*

If it is desired to compress two-dimensional groups of values of sets of values that comprise or represent sets of weights of a series of adjacent fully connected layers in a manner that the neural network can subsequently be implemented without needing to "undo" the reordering of the rows and/or columns of the matrix that represent the channels of those sets of weights during decompression, this can be achieved by performing the following computer-implemented method.

A first matrix comprising a first set of values comprising or representing a first set of weights of a first layer of a neural network can be determined. The first layer may be a fully connected layer. The one or more rows or columns of the first matrix may be representative of the one or more output channels of the first layer and the one or more other of the rows or columns of the first matrix may be representative of the one or more input channels of the first layer. For example, the one or more rows of the first matrix may be representative of the one or more output channels of the first layer and the one or more columns of the first matrix may be representative of the one or more input channels of the first layer. Alternatively, the one or more columns of the first matrix may be representative of the one or more output channels of the first layer and the one or more rows of the first matrix may be representative of the one or more input channels of the first layer. This step can be performed in an analogous manner to step S202 described herein.

A second matrix comprising a second set of values comprising or representing a second set of weights of a second, subsequent, layer of the neural network can be determined. The second layer may be a fully connected layer. The one or more rows or columns of the second matrix may be representative of the one or more output channels of the second layer and the one or more other of the rows or columns of the second matrix may be representative of the one or more input channels of the second layer. For example, the one or more rows of the second matrix may be representative of the one or more output channels of the second layer and the one or more columns of the second matrix may be representative of the one or more input channels of the second layer. Alternatively, the one or more columns of the second matrix may be representative of the one or more output channels of the second layer and the one or more rows of the second matrix may be representative of the one or more input channels of the second layer. This step can be performed in an analogous manner to step S202 described herein.

The first and second matrices are determined in a "consistent" manner - e.g. such that the rows or columns of both the first matrix and the second matrix represent the same type of channel (e.g. input or output channel). For example, the one or more rows of the first matrix may be representative of the one or more output channels of the first layer, the one or more columns of the first matrix may be representative of the one or more input channels of the first layer, the one or more rows of the second matrix may be representative of the one or more output channels of the second layer, and the one or more columns of the second matrix may be representative of the one or more input channels of the second layer. Alternatively, the one or more columns of the first matrix may be representative of the one or more output channels of the first layer, the one or more rows of the first matrix may be representative of the one or more input channels of the first layer, the one or more columns of the second matrix may be representative of the one or more output channels of the second layer, and the one or more rows of the second matrix may be representative of the one or more input channels of the second layer. The one or more output channels of the first layer represented by the rows or columns of the first matrix correspond to (e.g. are responsible for forming channels of activation data to be operated on by) the one or more input channels of the second layer represented by the rows or columns of the second matrix.

An array can be formed by transposing the first matrix and forming the array comprising the transposed first matrix and the second matrix by aligning the columns or rows of the transposed first matrix that are representative of the one or more output channels of the first layer with the columns or rows of the second matrix that are representative of the one or more input channels of the second layer. For example, for 1 to N, the $N^{th}$ column of the transposed first matrix that is representative of the $N^{th}$ output channel of the first layer can be aligned with (e.g. included in the same column of the array as) the $N^{th}$ column of the second matrix that is representative of the $N^{th}$ input channel of the second layer - where the $N^{th}$ output channel of the first layer corresponds with (e.g. is responsible for forming the channel of output activation data that will be operated on by) the $N^{th}$ input channel of the second layer. Alternatively, for 1 to N, the $N^{th}$ row of the transposed first matrix that is representative of the $N^{th}$ output channel of the first layer can be aligned with (e.g. included in the same row of the array as) the $N^{th}$ row of the second matrix that is representative of the $N^{th}$ input channel of the second layer - where the $N^{th}$ output channel of the first layer corresponds with (e.g. is responsible for forming the channel of output activation data that will be operated on by) the $N^{th}$ input channel of the second layer. In other words, within the array, each output channel of the first layer is aligned with its corresponding input channel of the second layer.

Alternatively, an array can be formed by transposing the second matrix and forming the array comprising the transposed second matrix and the first matrix by aligning the rows or columns of the transposed second matrix that are representative of the one or more input channels of the second layer with the rows or columns of the first matrix that are representative of the one or more output channels of the first layer. For example, for 1 to N, the $N^{th}$ row of the first matrix that is representative of the $N^{th}$ output channel of the first layer can be aligned with (e.g. placed in the same row of the array as) the $N^{th}$ row of the transposed second matrix that is representative of the $N^{th}$ input channel of the second layer - where the $N^{th}$ output channel of the first layer corresponds with (e.g. is responsible for forming the channel of output data that will be operated on by) the $N^{th}$ input channel of the second layer. Alternatively, for 1 to $N$, the $N^{th}$ column of the first matrix that is representative of the $N^{th}$ output channel of the first layer can be aligned with (e.g. placed in the same column of the array as) the $N^{th}$ column of the transposed second matrix that is representative of the $N^{th}$ input channel of the second layer - where the $N^{th}$ output channel of the first layer corresponds with (e.g. is responsible for forming the channel of output data that will be operated on by) the $N^{th}$ input channel of the second layer. In other words, within the array, each output channel of the first layer is aligned with its corresponding input channel of the second layer.

In general, to form an array according to the principles described herein, the matrix determined for every-other layer in a series of adjacent layers can be transposed, such that the corresponding output channels and input channels of adjacent layers within that series can be aligned. The first matrix to be transposed can be either the matrix determined for the first layer in a series of adjacent layers, or the matrix determined for the second layer in that series of adjacent layers - with the matrix determined for every-other layer in that series of adjacent layers being transposed thereafter.

This step can be understood with reference to Figure 11A - which shows an example array 1104. The array 1104 of Figure 11A is formed by transposing the first matrix 1100-1 and forming the array 1104 comprising the transposed first matrix, $(1100-1)^{T}$, and the second matrix 1100-2 by aligning the columns of the transposed first matrix, $(1100-1)^{T}$, that are representative of the one or more output channels of the first layer with the columns of the second matrix 1100-2 that are representative of the one or more input channels of the second layer.

To aid the reader's understanding, Figure 11A also shows a transposed third matrix, $(1100-3)^{T}$, that has been determined by transposing a third matrix determined for a third layer of the neural network that is adjacent to, and subsequent to, the second layer. In the array 1104, the rows of the second matrix 1100-2 that are representative of the one or more output channels of the second layer are aligned with the rows of the transposed third matrix, $(1100-3)^{T}$, that are representative of the one or more input channels of the third layer. Also shown in Figure 11A is a fourth matrix 1100-4 that has been determined for a fourth layer of the neural network that is adjacent to, and subsequent to, the third layer. In the array 1104, the columns of the transposed third matrix, $(1100-3)^{T}$, that are representative of the one or more output channels of the third layer are aligned with the columns of the fourth matrix 1100-4 that are representative of the one or more input channels of the fourth layer. The transposed third matrix, $(1100\text{-}3)^T$, and fourth matrix 1100-4 are shown in the array 1104 of Figure 11A to illustrate that the method described herein can be applied to a series of more than two adjacent layers of a neural network. In fact, the method described herein can be applied to any number of adjacent layers of a neural network.

The array 1104 of Figure 11A shows the plurality of matrices arranged from the top-right corner of the array 1104 to the bottom-left corner of the array 1104 in a step-down, step-left pattern. It is to be understood that the same plurality of matrices (e.g. $(1100\text{-}1)^T$, 1100-2, $(1100\text{-}3)^T$ and 1100-4) could alternatively be arranged: from the top-left corner of the array to the bottom-right corner of the array in a step-down, step-right pattern; from the bottom-left corner of the array to the top-right corner of the array in a step-up, step-right pattern; or from the bottom-right corner of the array to the top-left corner of the array in a step-up, step-left pattern. In the alternative example where the array is formed by transposing the second matrix 1100-2, the plurality of matrices (e.g. 1100-1, $(1100\text{-}2)^T$, 1100-3 and $(1100\text{-}4)^T$) could be arranged: from the top-right corner of the array to the bottom-left corner of the array in a step-left, step-down pattern; from the top-left corner of the array to the bottom-right corner of the array in a step-right, step-down pattern; from the bottom-left corner of the array to the top-right corner of the array in a step-right, step-up pattern; or from the bottom-right corner of the array to the top-left corner of the array in a step-left, step-up pattern.

A similarity between pairs of rows and pairs of columns of the array can be assessed. This step can be performed in an analogous manner to step S204 described herein. Assessing the similarity between pairs of columns of the array may comprise, for each column of the array, assessing the similarity between that column of the array and, respectively (e.g. separately, or independently), each other column of the array within the range of columns spanned by the matrices occupying that column of the array. For example, referring to Figure 11A, the similarity between column 9 and, respectively, each of columns 10 to 16 may be assessed. That is, the similarity between column 9 and, respectively, each of columns 1 to 8 need not be assessed. Assessing the similarity between pairs of rows of the array may comprise, for each row of the array, assessing the similarity between that row of the array and, respectively (e.g. separately, or independently), each other row of the array within the range of rows spanned by the matrices occupying that row of the array. For example, referring to Figure 11A, the similarity between row 9 and, respectively, each of rows 10 to 16 may be assessed. That is, the similarity between row 9 and, respectively, each of rows 1 to 8 and 17 to 24 need not be assessed.

The rows and columns of the array can be reordered in dependence on the similarity between the pairs of rows and pairs of columns of the array so as to form a plurality of groups of values of the first set of values and a plurality of groups of values of the second set of values. In other words, a two-dimensional ordering of the array can be performed. This step can be performed in an analogous manner to step S206 described herein. The reordering of the rows and columns of the array may be constrained such that the rows and columns of each matrix within the array can only be rearranged to row and column positions within the range of rows and columns of the array that that matrix originally spanned. For example, referring to Figure 11A, the rows and columns of matrix $(1100\text{-}1)^T$ can only be rearranged to row and column positions within the range of rows 1 to 8 and columns 9 to 16 of the array.

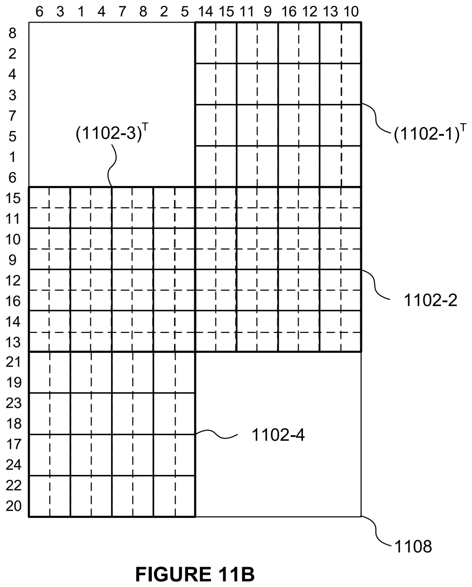

This step can be understood with reference to Figure 11B - which shows an array, the rows and columns of which have been reordered so as to form a plurality of two-dimensional groups of values. The array 1108 shown in Figure 11B can be formed by reordering the rows and columns of the array 1104 shown in Figure 11A. That is, Figure 11B shows the rows and columns of the array 1104 shown in Figure 11A in a different order. By rearranging the rows and columns of the array 1104 in this way, the rows and columns of each of the matrices (e.g. $(1100\text{-}1)^T$, 1100-2, $(1100\text{-}3)^T$ and 1100-4) are reordered (e.g. simultaneously). The plurality of two-dimensional groups of values are illustrated using solid borders. In the example shown in Figure 11B, the matrix $(1102\text{-}1)^T$ comprises a plurality of (e.g. 16, in Figure 11B) groups of values of the first set of values, the matrix 1102-2 comprises a plurality of (e.g. 16, in Figure 11B) groups of values of the second set of values, the matrix $(1102\text{-}3)^T$ comprises a plurality of (e.g. 16, in Figure 11B) groups of values of the third set of values and the matrix $(1102\text{-}4)^T$ comprises a plurality of (e.g. 16, in Figure 11B) groups of values of the fourth set of values.

Forming the array as described herein such that series of elements (e.g. rows or columns) representative of the one or more output channels of the first layer are aligned with (i.e. included within the same rows or columns of the array as) the series of elements (e.g. rows or columns) representative of the one or more corresponding input channels of the second, subsequent layer, means that, when the rows and columns of that array are reordered, the series of elements (e.g. row or column) representative of each output channel of the first layer remains aligned with (i.e. included within the same row or column of the array as) the series of elements (e.g. row or column) representative of the respective, corresponding, input channel of the second, subsequent layer. This enables the output-input dependencies between the first layer and the second layer to be preserved through the reordering of the array. More generally, by applying these principles to form and reorder an array, the output-input dependencies between each pair of adjacent layers of a series of two or more adjacent layers for which the method described is performed can be preserved. In other words, by applying these principles, the reordering of the input channels of each "subsequent" layer performed during the compression corresponds to the reordering of the corresponding output channels of each "preceding" layer performed during the compression.

At least one group of values of the plurality of groups of values of the first set of values can be compressed so as to compress the first set of values. This step can be performed in an analogous manner to step S208 described herein. At least one group of values of the plurality of groups of values of the second set of values can be compressed so as to compress the second set of values. This step can be performed in an analogous manner to step S208 described herein. The groups of values comprised by the matrix or matrices that were transposed when forming the array (e.g. the first and third matrix in Figure 11A) can be transposed (i.e. "transposed back") before compression, or subsequently during decompression. The compressed first set of values can be stored to memory for subsequent use in implementing a neural network, as described herein. The compressed second set of values can be stored to memory for subsequent use in implementing a neural network, as described herein. The method described herein may further comprise configuring the neural network in dependence on the compressed first and second sets of values, e.g. configuring the neural network to process neural network activation data using weights, the input and output channels of which are reordered in accordance with the reordering of the rows and columns of the first and second matrices caused by reordering the array.

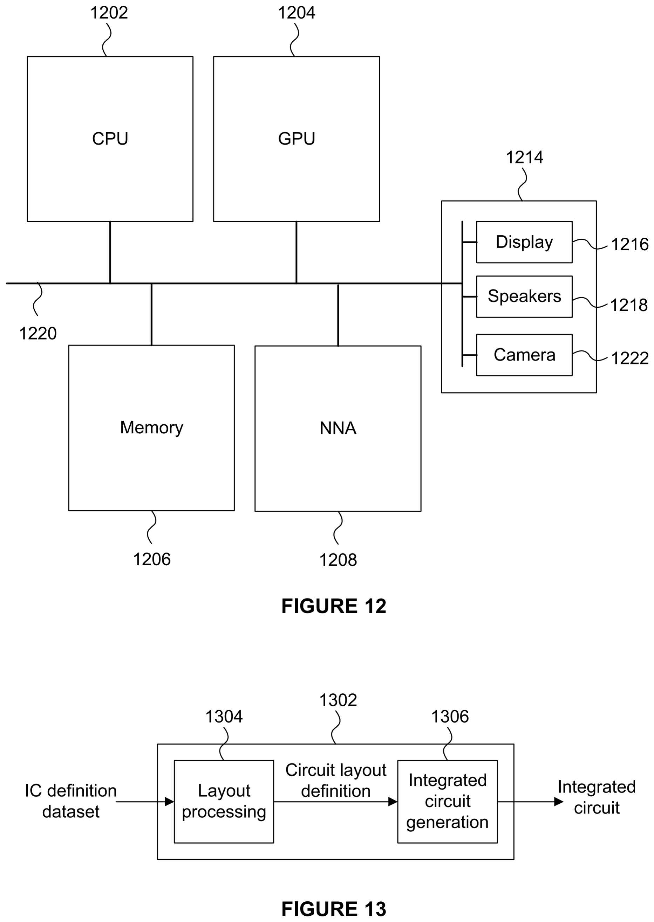

Figure 12 shows a computer system in which the processing system described herein may be implemented. The computer system comprises a CPU 1202, a GPU 1204, a memory 1206, a neural network accelerator (NNA) 1208 and other devices 1214, such as a display 1216, speakers 1218 and a camera 1222. In other examples, one or more of the depicted components may be omitted from the system. The components of the computer system can communicate with each other via a communications bus 1220. Memory 1206 may correspond to memory 104 described with reference to in Figure 1. In some examples, CPU 1202 and/or a GPU 1204 may perform the functions of processing logic 102 described with reference to Figure 1, and may write a set of values compressed according to the principles described herein to memory 1206. In some examples, a set of values compressed according to the principles described herein can be stored in memory 1206, that compressed set of values encoding a set of weights of a neural network. In these examples, that neural network can be implemented, e.g. at GPU 1204 and/or NNA 1208, using the compressed set of values - e.g. by reading the compressed set of values from memory 1206 into GPU 1204 and/or NNA 1208, decompressing that set of values at GPU 1204 and/or NNA 1208 so as to generate a set of weights of the neural network, and then operating on neural network activation data at GPU 1204 and/or NNA 1208 using the decompressed set of weights. The implemented neural network can be configured to perform image processing as described herein - e.g. the processing of images captured by camera 1222.

The processing system of Figure 1 is shown as comprising a number of functional blocks. This is schematic only and is not intended to define a strict division between different logic elements of the processing system. Each functional block may be provided in any suitable manner. It is to be understood that intermediate values described herein as being formed by the processing system need not be physically generated by the processing system at any point and may merely represent logical values which conveniently describe the processing performed by the processing system between its input and output.

The processing system described herein may be embodied in hardware on an integrated circuit. The processing system described herein may be configured to perform any of the methods described herein. Generally, any of the functions, methods, techniques or components described above can be implemented in software, firmware, hardware (e.g., fixed logic circuitry), or any combination thereof. The terms "module," "functionality," "component", "element", "unit", "block" and "logic" may be used herein to generally represent software, firmware, hardware, or any combination thereof. In the case of a software implementation, the module, functionality, component, element, unit, block or logic represents program code that performs the specified tasks when executed on a processor. The algorithms and methods described herein could be performed by one or more processors executing code that causes the processor(s) to perform the algorithms/methods. Examples of a computer-readable storage medium include a random-access memory (RAM), read-only memory (ROM), an optical disc, flash memory, hard disk memory, and other memory devices that may use magnetic, optical, and other techniques to store instructions or other data and that can be accessed by a machine.

The terms computer program code and computer readable instructions as used herein refer to any kind of executable code for processors, including code expressed in a machine language, an interpreted language or a scripting language. Executable code includes binary code, machine code, bytecode, code defining an integrated circuit (such as a hardware description language or netlist), and code expressed in a programming language code such as C, Java or OpenCL. Executable code may be, for example, any kind of software, firmware, script, module or library which, when suitably executed, processed, interpreted, compiled, executed at a virtual machine or other software environment, cause a processor of the computer system at which the executable code is supported to perform the tasks specified by the code.

A processor, computer, or computer system may be any kind of device, machine or dedicated circuit, or collection or portion thereof, with processing capability such that it can execute instructions. A processor may be or comprise any kind of general purpose or dedicated processor, such as a CPU, GPU, NNA, System-on-chip, state machine, media processor, an application-specific integrated circuit (ASIC), a programmable logic array, a field-programmable gate array (FPGA), or the like. A computer or computer system may comprise one or more processors.

It is also intended to encompass software which defines a configuration of hardware as described herein, such as HDL (hardware description language) software, as is used for designing integrated circuits, or for configuring programmable chips, to carry out desired functions. That is, there may be provided a computer readable storage medium having encoded thereon computer readable program code in the form of an integrated circuit definition dataset that when processed (i.e. run) in an integrated circuit manufacturing system configures the system to manufacture a processing system configured to perform any of the methods described herein, or to manufacture a processing system comprising any apparatus described herein. An integrated circuit definition dataset may be, for example, an integrated circuit description.

Therefore, there may be provided a method of manufacturing, at an integrated circuit manufacturing system, a processing system as described herein. Furthermore, there may be provided an integrated circuit definition dataset that, when processed in an integrated circuit manufacturing system, causes the method of manufacturing a processing system to be performed.

An integrated circuit definition dataset may be in the form of computer code, for example as a netlist, code for configuring a programmable chip, as a hardware description language defining hardware suitable for manufacture in an integrated circuit at any level, including as register transfer level (RTL) code, as high-level circuit representations such as Verilog or VHDL, and as low-level circuit representations such as OASIS (RTM) and GDSII. Higher level representations which logically define hardware suitable for manufacture in an integrated circuit (such as RTL) may be processed at a computer system configured for generating a manufacturing definition of an integrated circuit in the context of a software environment comprising definitions of circuit elements and rules for combining those elements in order to generate the manufacturing definition of an integrated circuit so defined by the representation. As is typically the case with software executing at a computer system so as to define a machine, one or more intermediate user steps (e.g. providing commands, variables etc.) may be required in order for a computer system configured for generating a manufacturing definition of an integrated circuit to execute code defining an integrated circuit so as to generate the manufacturing definition of that integrated circuit.

An example of processing an integrated circuit definition dataset at an integrated circuit manufacturing system so as to configure the system to manufacture a processing system will now be described with respect to Figure 13.

Figure 13 shows an example of an integrated circuit (IC) manufacturing system 1302 which is configured to manufacture a processing system as described in any of the examples herein. In particular, the IC manufacturing system 1302 comprises a layout processing system 1304 and an integrated circuit generation system 1306. The IC manufacturing system 1302 is configured to receive an IC definition dataset (e.g. defining a processing system as described in any of the examples herein), process the IC definition dataset, and generate an IC according to the IC definition dataset (e.g. which embodies a processing system as described in any of the examples herein). The processing of the IC definition dataset configures the IC manufacturing system 1302 to manufacture an integrated circuit embodying a processing system as described in any of the examples herein.

The layout processing system 1304 is configured to receive and process the IC definition dataset to determine a circuit layout. Methods of determining a circuit layout from an IC definition dataset are known in the art, and for example may involve synthesising RTL code to determine a gate level representation of a circuit to be generated, e.g. in terms of logical components (e.g. NAND, NOR, AND, OR, MUX and FLIP-FLOP components). A circuit layout can be determined from the gate level representation of the circuit by determining positional information for the logical components. This may be done automatically or with user involvement in order to optimise the circuit layout. When the layout processing system 1304 has determined the circuit layout it may output a circuit layout definition to the IC generation system 1306. A circuit layout definition may be, for example, a circuit layout description.

The IC generation system 1306 generates an IC according to the circuit layout definition, as is known in the art. For example, the IC generation system 1306 may implement a semiconductor device fabrication process to generate the IC, which may involve a multiple-step sequence of photo lithographic and chemical processing steps during which electronic circuits are gradually created on a wafer made of semiconducting material. The circuit layout definition may be in the form of a mask which can be used in a lithographic process for generating an IC according to the circuit definition. Alternatively, the circuit layout definition provided to the IC generation system 1306 may be in the form of computer-readable code which the IC generation system 1306 can use to form a suitable mask for use in generating an IC.

The different processes performed by the IC manufacturing system 1302 may be implemented all in one location, e.g. by one party. Alternatively, the IC manufacturing system 1302 may be a distributed system such that some of the processes may be performed at different locations, and may be performed by different parties. For example, some of the stages of: (i) synthesising RTL code representing the IC definition dataset to form a gate level representation of a circuit to be generated, (ii) generating a circuit layout based on the gate level representation, (iii) forming a mask in accordance with the circuit layout, and (iv) fabricating an integrated circuit using the mask, may be performed in different locations and/or by different parties.

In other examples, processing of the integrated circuit definition dataset at an integrated circuit manufacturing system may configure the system to manufacture a processing system without the IC definition dataset being processed so as to determine a circuit layout. For instance, an integrated circuit definition dataset may define the configuration of a reconfigurable processor, such as an FPGA, and the processing of that dataset may configure an IC manufacturing system to generate a reconfigurable processor having that defined configuration (e.g. by loading configuration data to the FPGA).

In some embodiments, an integrated circuit manufacturing definition dataset, when processed in an integrated circuit manufacturing system, may cause an integrated circuit manufacturing system to generate a device as described herein. For example, the configuration of an integrated circuit manufacturing system in the manner described above with respect to Figure 13 by an integrated circuit manufacturing definition dataset may cause a device as described herein to be manufactured.

In some examples, an integrated circuit definition dataset could include software which runs on hardware defined at the dataset or in combination with hardware defined at the dataset. In the example shown in Figure 13, the IC generation system may further be configured by an integrated circuit definition dataset to, on manufacturing an integrated circuit, load firmware onto that integrated circuit in accordance with program code defined at the integrated circuit definition dataset or otherwise provide program code with the integrated circuit for use with the integrated circuit.

The implementation of concepts set forth in this application in devices, apparatus, modules, and/or systems (as well as in methods implemented herein) may give rise to performance improvements when compared with known implementations. The performance improvements may include one or more of increased computational performance, reduced latency, increased throughput, and/or reduced power consumption. During manufacture of such devices, apparatus, modules, and systems (e.g. in integrated circuits) performance improvements can be traded-off against the physical implementation, thereby improving the method of manufacture. For example, a performance improvement may be traded against layout area, thereby matching the performance of a known implementation but using less silicon. This may be done, for example, by reusing functional blocks in a serialised fashion or sharing functional blocks between elements of the devices, apparatus, modules and/or systems. Conversely, concepts set forth in this application that give rise to improvements in the physical implementation of the devices, apparatus, modules, and systems (such as reduced silicon area) may be traded for improved performance. This may be done, for example, by manufacturing multiple instances of a module within a predefined area budget.

The applicant hereby discloses in isolation each individual feature described herein and any combination of two or more such features, to the extent that such features or combinations are capable of being carried out based on the present specification as a whole in the light of the common general knowledge of a person skilled in the art, irrespective of whether such features or combinations of features solve any problems disclosed herein. In view of the foregoing description it will be evident to a person skilled in the art that various modifications may be made within the scope of the invention.

## Claims

1. A computer-implemented method of compressing a set of values, the method comprising:

   determining a matrix comprising the set of values;
   assessing a similarity between pairs of rows and/or pairs of columns of the matrix;
   reordering the rows and/or columns of the matrix in dependence on the similarity between the pairs of rows and/or pairs of columns so as to form a plurality of groups of values of the set of values; and
   compressing at least one group of values of the plurality of groups of values so as to compress the set of values.

2. The computer-implemented method of claim 1, wherein compressing a group of values comprises:

   determining a plurality of encodable values in dependence on that group of values;
   identifying a sufficient number of bits required to encode the encodable value of the plurality of encodable values that has the greatest magnitude; and
   encoding each of the encodable values of the plurality of encodable values using that number of bits.

3. The computer-implemented method of claim 1 or 2, wherein assessing the similarity between the pairs of rows and/or the pairs of columns of the matrix comprises:

   assessing the similarity in values comprised by the pairs of rows and/or the pairs of columns of the matrix; and/or
   assessing the similarity in the minimum number of bits required to encode values comprised by the pairs of rows and/or the pairs of columns of the matrix.

4. The computer-implemented method of any of claims 1 to 3, wherein assessing the similarity between the pairs of rows and/or the pairs of columns of the matrix comprises determining one or more of an L1 distance, an L2 distance, a cosine similarity and a Minkowski distance between:

   the values comprised by the pairs of rows and/or the pairs of columns of the matrix; and/or

the minimum number of bits required to encode values comprised by the pairs of rows and/or the pairs of columns of the matrix.

5. The computer-implemented method of any preceding claim, wherein compressing the at least one group of values comprises compressing one or more groups of values according to a first compression scheme in which, for each of said one or more groups of values, each value of that group of values is encoded using a number of bits sufficient to represent the value in that group of values that has the greatest magnitude.

6. The computer-implemented method of any preceding claim, wherein compressing the at least one group of values comprises compressing one or more groups of values according to a second compression scheme in which, for each of the one or more groups of values:

   a base value is determined in dependence on the values of that group of values;
   for each of one or more values of that group of values, a respective difference between that value and the base value is determined;
   the base value is encoded using a number of bits sufficient to represent the base value; and
   each of the one or more differences are encoded using a number of bits sufficient to represent the difference of the one or more differences that has the greatest magnitude.

7. The computer-implemented method of any preceding claim, wherein compressing the at least one group of values comprises compressing one or more groups of values according to a third compression scheme in which, for each of the one or more groups of values:

   a base value is determined in dependence on the values of that group of values;
   a base difference is determined between the base value and a first value of that group of values;
   for each of one or more values of that group of values other than the first value, a respective adjacency difference between that value and an adjacent value of that group of values is determined;
   the base value is encoded using a number of bits sufficient to represent the base value; and
   each of the base difference and the one or more adjacency differences are encoded using a number of bits sufficient to represent the difference of the base difference and the one or more adjacency differences that has the greatest magnitude.

8. The computer-implemented method of claims 5 and 6, claims 5 and 7, claims 6 and 7, or claims 5 to 7, wherein compressing the at least one group of values comprises, for each of one or more groups of values to be compressed:

   assessing the number of bits that would be required to encode that group of values according to two or more of the first compression scheme, the second compression scheme and the third compression scheme; and
   compressing that group of values according to the compression scheme of the assessed compression schemes that will require the fewest number of bits to encode that group of values.

9. The computer-implemented method of any preceding claim, the set of values comprising or representing a set of weights of a layer of a neural network.

10. The computer implemented method of claim 9, the method comprising, so as to form the plurality of groups of values of the set of values:

    reordering the rows or columns of the matrix in dependence on the similarity between the pairs of rows or pairs of columns; and
    reordering the other of the rows or columns of the matrix to correspond with the reordering of rows or columns of a further matrix comprising a further set of values comprising or representing a further set of weights of an adjacent layer of the neural network.

11. The computer implemented method of claim 9 or 10, wherein the rows of the matrix are representative of output channels of the set of weights of the layer of the neural network and the columns of the matrix are representative of input channels of the set of weights of the layer of the neural network, and the method comprises, so as to form the plurality of groups of values of the set of values:

    reordering the rows of the matrix in dependence on the similarity between the pairs of rows, and reordering the columns of the matrix to correspond with the reordering of rows of a further matrix comprising a further set of values comprising or representing a further set of weights of a preceding layer of the neural network, said rows of the further matrix being representative of output channels of the further set of weights of the preceding layer that correspond with the input channels of the layer represented by the columns of the matrix; or

reordering the columns of the matrix in dependence on the similarity between the pairs of columns, and reordering the rows of the matrix to correspond with the reordering of columns of a further matrix comprising a further set of values comprising or representing a further set of weights of a subsequent layer of the neural network, said columns of the further matrix being representative of input channels of the further set of weights of the subsequent layer that correspond with the output channels of the layer represented by the rows of the matrix.

12. The computer implemented method of claim 9 or 10, wherein the columns of the matrix are representative of output channels of the set of weights of the layer of the neural network and the rows of the matrix are representative of input channels of the set of weights of the layer of the neural network, and the method comprises, so as to form the plurality of groups of values of the set of values:

reordering the rows of the matrix in dependence on the similarity between the pairs of rows, and reordering the columns of the matrix to correspond with the reordering of rows of a further matrix comprising a further set of values comprising or representing a further set of weights of a subsequent layer of the neural network, said rows of the further matrix being representative of input channels of the further set of weights of the subsequent layer that correspond with the output channels of the layer represented by the columns of the matrix; or

reordering the columns of the matrix in dependence on the similarity between the pairs of columns, and reordering the rows of the matrix to correspond with the reordering of columns of a further matrix comprising a further set of values comprising or representing a further set of weights of a preceding layer of the neural network, said columns of the further matrix being representative of output channels of the further set of weights of the preceding layer that correspond with the input channels of the layer represented by the rows of the matrix.

13. The computer-implemented method of any of claims 9 to 12, the set of values comprising or representing a set of weights of a first two-dimensional plane of a four-dimensional set of weights of a convolutional layer of the neural network, the method further comprising:

determining a second matrix comprising a second set of values, the second set of values comprising or representing a second set of weights of a second two-dimensional plane of the four-dimensional set of weights of the convolutional layer of the neural network;

assessing a similarity between pairs of rows and/or pairs of columns of the second matrix;

combining the assessed similarity between the pairs of rows and/or pairs of columns of the matrix and the assessed similarity between the corresponding pairs of rows and/or pairs of columns of the second matrix;

reordering the rows and/or columns of the matrix in dependence on the combined assessed similarity so as to form the plurality of groups of values of the set of values;

reordering the rows and/or columns of the second matrix in dependence on the combined assessed similarity so as to form a plurality of groups of values of the second set of values, wherein the reordering of the rows and/or columns of the second matrix corresponds with the reordering of the rows and/or columns of the matrix; and

compressing at least one group of values of the plurality of groups of values of the second set of values so as to compress the second set of values.

14. Computer readable code configured to cause the method of any of claims 1 to 13 to be performed when the code is run.

15. A processing system configured to compress a set of values, the processing system comprising:

matrix logic configured to determine a matrix comprising the set of values;

similarity logic configured to assess a similarity between pairs of rows and/or pairs of columns of the matrix;

reordering logic configured to reorder the rows and/or columns of the matrix in dependence on the similarity between the pairs of rows and/or pairs of columns so as to form a plurality of groups of values; and

compression logic configured to compress at least one group of values of the plurality of groups of values.

102

| Matrix Logic 106 | Similarity Logic 108 |
|---|---|
| Reordering Logic 110 | Compression Logic 112 |

Memory

104

Processing system 100

**FIGURE 1**

S202 — Determining a matrix comprising a set of values

S204 — Assess a similarity between pairs of rows and/or pairs of columns of the matrix

S206 — Re-order the rows and/or columns of the matrix so as to form groups of values

S208 — Compress at least one group of values

**FIGURE 2**

**FIGURE 3**

**FIGURE 4**

**FIGURE 5A**

**FIGURE 5B**

**FIGURE 5C**

**FIGURE 7**

```
       1   2   3   4   5   6   7   8   9  10  11  12  13  14  15  16
 1 [12  13  13  13  15  13  15  12  12  14  14  15  14  14  12  15]
 2 [ 8   9   9   9  11   9  11   8   8  10  10  11  10  10   8  11]
 3 [ 8   9   9   9  11   9  11   8   8  10  10  11  10  10   8  11]
 4 [ 8   9   9   9  11   9  11   8   8  10  10  11  10  10   8  11]
 5 [12  13  13  13  15  13  15  12  12  14  14  15  14  14  12  15]
 6 [12  13  13  13  15  13  15  12  12  14  14  15  14  14  12  15]
 7 [ 4   5   5   5   7   5   7   4   4   6   6   7   6   6   4   7]
 8 [ 4   5   5   5   7   5   7   4   4   6   6   7   6   6   4   7]
 9 [ 0   1   1   1   3   1   3   0   0   2   2   3   2   2   0   3]
10 [ 0   1   1   1   3   1   3   0   0   2   2   3   2   2   0   3]
11 [ 8   9   9   9  11   9  11   8   8  10  10  11  10  10   8  11]
12 [ 4   5   5   5   7   5   7   4   4   6   6   7   6   6   4   7]
13 [ 4   5   5   5   7   5   7   4   4   6   6   7   6   6   4   7]
14 [12  13  13  13  15  13  15  12  12  14  14  15  14  14  12  15]
15 [ 0   1   1   1   3   1   3   0   0   2   2   3   2   2   0   3]
16 [ 0   1   1   1   3   1   3   0   0   2   2   3   2   2   0   3]
```

→

```
       1   8   9  15   2   3   4   6   5   7  12  16  10  11  13  14
 9 [ 0   0   0   0   1   1   1   1   3   3   3   3   2   2   2   2]
10 [ 0   0   0   0   1   1   1   1   3   3   3   3   2   2   2   2]
15 [ 0   0   0   0   1   1   1   1   3   3   3   3   2   2   2   2]
16 [ 0   0   0   0   1   1   1   1   3   3   3   3   2   2   2   2]
 2 [ 8   8   8   8   9   9   9   9  11  11  11  11  10  10  10  10]
 3 [ 8   8   8   8   9   9   9   9  11  11  11  11  10  10  10  10]
 4 [ 8   8   8   8   9   9   9   9  11  11  11  11  10  10  10  10]
11 [ 8   8   8   8   9   9   9   9  11  11  11  11  10  10  10  10]
 7 [ 4   4   4   4   5   5   5   5   7   7   7   7   6   6   6   6]
 8 [ 4   4   4   4   5   5   5   5   7   7   7   7   6   6   6   6]
12 [ 4   4   4   4   5   5   5   5   7   7   7   7   6   6   6   6]
13 [ 4   4   4   4   5   5   5   5   7   7   7   7   6   6   6   6]
 1 [12  12  12  12  13  13  13  13  15  15  15  15  14  14  14  14]
 5 [12  12  12  12  13  13  13  13  15  15  15  15  14  14  14  14]
 6 [12  12  12  12  13  13  13  13  15  15  15  15  14  14  14  14]
14 [12  12  12  12  13  13  13  13  15  15  15  15  14  14  14  14]
```

600

602

**FIGURE 6**

**FIGURE 8a**

**FIGURE 8b**

**FIGURE 9**

**FIGURE 11A**

**FIGURE 10**

**FIGURE 11B**

**FIGURE 12**

**FIGURE 13**

Europäisches
Patentamt

European
Patent Office

Office européen
des brevets

# EUROPEAN SEARCH REPORT

**Application Number**

EP 25 22 4298

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 99/64944 A2 (MICROSOFT CORP [US]) 16 December 1999 (1999-12-16) | 1-10,14, 15 | INV. H03M7/30 |
| A | * abstract; claims; figures * * page 27 - page 30 * | 11-13 | |
| X | DU QINXIN ET AL: "Optimizing Data Compression via Data Reordering", 2024 34TH INTERNATIONAL CONFERENCE ON COLLABORATIVE ADVANCES IN SOFTWARE AND COMPUTING (CASCON) IEEE, 11 November 2024 (2024-11-11), pages 1-10, XP034804005, DOI: 10.1109/CASCON62161.2024.10838201 [retrieved on 2025-01-17] | 1-10,14, 15 | |
| A | * page 1 - page 6 * | 11-13 | |
| X | SHARLEE CLIMER ET AL: "Rearrangement Clustering: Pitfalls, Remedies, and Applications", JOURNAL OF MACHINE LEARNING RESEARCH MIT PRESS , CAMBRIDGE , MA, US, vol. 7, 1 December 2006 (2006-12-01), pages 919-943, XP058157747, ISSN: 1532-4435 | 1-5, 8-10,14, 15 | |
| A | * page 919 - page 929 * | 6,7, 11-13 | |
| X | DAVID JOHNSON ET AL: "Compressing large boolean matrices using reordering techniques", PROCEEDINGS OF THE THIRTIETH INTERNATIONAL CONFERENCE ON VERY LARGE DATA BASES VLDB ENDOWMENT, 31 August 2004 (2004-08-31), pages 13-23, XP058392305, ISBN: 9780120884698 | 1-5, 8-10,14, 15 | |
| A | * page 13 - page 19 * | 6,7, 11-13 | |

**TECHNICAL FIELDS SEARCHED (IPC)**

H03M

-----

-/--

The present search report has been drawn up for all claims

| Place of search | Date of completion of the search | Examiner |
|---|---|---|
| The Hague | 17 April 2026 | Scappazzoni, E |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 1 of 2

Europäisches
Patentamt

European
Patent Office

Office européen
des brevets

**EUROPEAN SEARCH REPORT**

Application Number

EP 25 22 4298

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | WO 2023/198817 A1 (FRAUNHOFER GES FORSCHUNG [DE]) 19 October 2023 (2023-10-19) * abstract; figures * ----- | 1-15 | |
| | | | **TECHNICAL FIELDS SEARCHED (IPC)** |

The present search report has been drawn up for all claims

| Place of search | Date of completion of the search | Examiner |
|---|---|---|
| The Hague | 17 April 2026 | Scappazzoni, E |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

...........................................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 22 4298

This annex lists the patent family members relating to the patent documents cited in the above-mentioned European search report.
The members are as contained in the European Patent Office EDP file on
The European Patent Office is in no way liable for these particulars which are merely given for the purpose of information.

17-04-2026

| Patent document cited in search report | | Publication date | Patent family member(s) | | Publication date |
|---|---|---|---|---|---|
| WO 9964944 | A2 | 16-12-1999 | AU | 4424899 A | 30-12-1999 |
| | | | EP | 1086412 A2 | 28-03-2001 |
| | | | JP | 4384813 B2 | 16-12-2009 |
| | | | JP | 2002517851 A | 18-06-2002 |
| | | | US | 6573890 B1 | 03-06-2003 |
| | | | US | 6606095 B1 | 12-08-2003 |
| | | | US | 6614428 B1 | 02-09-2003 |
| | | | WO | 9964944 A2 | 16-12-1999 |
| WO 2023198817 | A1 | 19-10-2023 | CN | 119384673 A | 28-01-2025 |
| | | | EP | 4508573 A1 | 19-02-2025 |
| | | | JP | 2025513886 A | 30-04-2025 |
| | | | KR | 20250003860 A | 07-01-2025 |
| | | | US | 2025045973 A1 | 06-02-2025 |
| | | | WO | 2023198817 A1 | 19-10-2023 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- GB 2418731 A

- GB 2623468 A